# EUROPÄISCHE PATENTANMELDUNG

(11) **EP 1 385 192 A2**
(43) Veröffentlichungstag der Anmeldung: **28.01.2004**
(21) Anmeldenummer: 03016239.0
(22) Anmeldetag: 17.07.2003
(51) Int. Cl.: H01J 29/70, H01J 37/26, H01J 37/30, G21K 1/08

(54) **Mit Strahlen geladener Teilchen arbeitende Anwendungen**

(30) Priorität: 18.07.2002 DE 10232689
(71) Anmelder: LEO Elektronenmikroskopie GmbH, 73446 Oberkochen (DE)
(72) Erfinder: Kienzle, Oliver, Dr., 73430 Aalen (DE); Knippelmeyer, Rainer, Dr., 73431 Aalen (DE)
(74) Vertreter: Schorr, Frank, Dr.

(57) **Zusammenfassung**

Es wird eine teilchenoptische Vorrichtung vorgeschlagen, welche zum Ablenken mehrerer separater strahlengeladener Teilchen eine teilchenoptische Linse umfasst, die durch eine Mehrzahl von entlang einer Öffnung der Linse vorgesehenen Fingerelektroden bereitgestellt ist.

## Beschreibung

Die Erfindung betrifft Anwendungen, die Strahlen geladener Teilchen einsetzen.

Insbesondere betrifft die Erfindung Anordnungen, die teilchenoptische Strahlen führen und formen, wie etwa Anordnungen zur Ablenkung, Kollimierung und Fokussierung von Strahlen geladener Teilchen.

Insbesondere betrifft die Erfindung auch Mikroskopiesysteme und Lithographiesysteme, welche Strahlen geladener Teilchen, insbesondere Elektronenstrahlen, zur Abbildung von Strukturen einsetzen.

Aus US 6,252,412 B1 ist eine Elektronenmikroskopievorrichtung zum Erfassen von Defekten in Halbleiterstrukturen bekannt. Dort soll die Fläche eines Wafers in möglichst kurzer Zeit abgetastet werden, um Defekte daran möglichst vollständig zu erfassen. Zur Erhöhung des Durchsatzes sind mehrere Elektronenmikroskopievorrichtungen nebeneinander gepackt, so daß mehrere Elektronenstrahlen parallel nebeneinander auf den Wafer gerichtet sind. Eine jede der mehreren Elektronenmikroskopievorrichturigen stellt für sich ein separates und selbständig funktionierendes Elektronenmikroskop dar. Die Dichte der Packung der mehreren Elektronenmikroskope ist somit durch die Querabmessung der einzelnen Elektronenmikroskope limitiert.

Es ist ein Ziel der vorliegenden Erfindung, hierzu alternative Vorrichtungen vorzuschlagen, welche mit mehreren Strahlen geladener Teilchen arbeiten und hierbei gegebenenfalls eine höhere Dichte von Strahlen zu ermöglichen oder/und die mehreren Strahlen mit unter gewissen Aspekten vereinfachten Komponenten bereitzustellen.

Ferner ist es eine Aufgabe der Erfindung alternative teilchenoptische Vorrichtungen und Strahlführungen vorzuschlagen, welche als Komponenten oder Baugruppen in teilchenoptischen Systemen einsetzbar sind.

Unter einem ersten Aspekt betrifft die Erfindung eine teilchenoptische Anordnung, welche als Rastermikroskopievorrichtung (SEM) einsetzbar ist. Bei einer Rastermikroskopievorrichtung wird ein teilchenoptisches Abbild eines Objekts dadurch gewonnen, daß ein feinfokussierter Sondenstrahl geladener Teilchen auf das Objekt gerichtet wird, der an dem Objekt Sekundärteilchen erzeugt, welche von einem Detektor registriert werden. Hierbei wird die Ortsauflösung der Abbildung dadurch gewonnen, daß die Position, an der der Sondenstrahl das Objekt trifft, bekannt ist und das Detektorsignal dieser Position zugeordnet wird.

Die erfindungsgemäße teilchenoptische Anordnung, insbesondere Rastermikroskopievorrichtung, arbeitet mit einer Mehrzahl von Sondenstrahlen und umfasst entsprechend zwei Strahlführungsanordnungen, nämlich eine erste Strahlführungsanordnung, um die Mehrzahl von Sondenstrahlen aus geladenen Teilchen im wesentlichen in einer Objektebene zu fokussieren, und eine zweite Strahlführungsanordnung, um die aus einem Bereich um die Objektebene ausgehenden Sekundärteilchen als Sekundärstrahlen zu einer Detektoranordnung zu führen. Hierbei können die erste und die zweite Strahlführungsanordnung integriert sein, das heißt gemeinsame Komponenten zur Strahlführung aufweisen, so daß Strahlengänge der Sondenstrahlen und der Sekundärstrahlen diese gemeinsamen Komponenten durchsetzen und teilweise überlagert sind.

Eine jede Strahlführungsanordnung weist ein oder mehrere Strahlumformungsanordnungen auf, welche auf die Strahlen einwirken, um diese beispielsweise zu kollimieren, zu fokussieren, abzulenken oder gewisse Eigenschaften der Strahlen zu korrigieren bzw. zu ändern. Es ist vorgesehen, wenigstens eine dieser Strahlumformungsanordnungen für die mehreren Sonden bzw. Sekundärstrahlen integral auszuführen, indem diese Strahlumformungsanordnung wenigstens eine Blende mit einer zusammenhängenden Öffnung für einen freien Durchtritt der mehreren Sondenstrahlen bzw. Sekundärstrahlen umfasst.

Im Unterschied zu der herkömmlichen Rastermikroskopievorrichtung mit mehreren Sondenstrahlen, bei der für einen jeden Sondenstrahl eine separate Strahlumformungsanordnung, wie etwa eine Objektivlinse, vorgesehen ist, welche eine eigene Bohrung mit um die Bohrung herum angeordneten Magnetspulen umfasst, erlaubt die erfindungsgemäße Anordnung eine nicht durch das Volumen der Wicklungen benachbarter Objektivlinsen limitierte Dichte der Strahlen nebeneinander, da die mehreren Strahlen durch eine gemeinsame Öffnung bzw. Bohrung geführt sind.

Ferner sind bei den herkömmlichen Mikroskopievorrichtungen Auslenkungen der Sondenstrahlen ebenfalls durch die Bohrungen der einzelnen Objektivlinsen beschränkt. Bei der erfindungsgemäßen Anordnung sind hingegen aufgrund der Zusammenfassung der mehreren Strahlen in einer gemeinsamen Öffnung grundsätzlich größere Auslenkungen möglich.

Die erste Strahlführungsanordnung umfasst vorzugsweise einen Strahlablenker, um die Orte, an denen die Sondenstrahlen in der Objektebene fokussiert sind, zu verlagern und damit die Objektebene "abzutasten" und mehreren Orten zugeordnete Sekundärteilchenintensitäten zu gewinnen.

Die Detektoranordnung ist hierbei vorzugsweise derart ausgebildet, daß für einen jeden Sondenstrahl die diesem zugeordnete Sekundärteilchenintensität erfassbar ist. Hierzu kann die Detektoranordnung eine Mehrzahl von separaten Detektoren umfassen, welche jeweils einem der Sondenstrahlen zugeordnet sind. Dies ist insbesondere dann vorteilhaft, wenn die von den einzelnen Sondenstrahlen erzeugten Sekundärstrahlen räumlich voneinander ausreichend separiert sind.

Es ist hier jedoch auch möglich, für die mehreren Sekundärstrahlen einen gemeinsamen Detektor vorzusehen, welcher Teilchenintensitäten ortsauflösend erfassen kann. Es ist dann eine Steuerung vorgesehen, welche einzelne Bereiche des ortsauflösenden Detektors derart identifiziert, daß ein jeder Bereich einem der Sondenstrahlen zugeordnet ist. Insbesondere ist es hierbei möglich, Verlagerungen der Sekundärstrahlen am Ort des Detektors Rechnung zu tragen, welche auf Verlagerungen bzw. Auslenkungen der Sondenstrahlen zurückgehen. Die Steuerung kann dann je nach Auslenkung verschiedene Bereiche des Detektors den einzelnen Sekundärstrahlen zuordnen.

Vorzugsweise stellt die Strahlumformungsanordnung mit der von den mehreren Strahlen durchsetzten Blende eine Komponente einer Objektivanordnung zur Fokussierung der Sondenstrahlen bereit, wobei dann insbesondere auch die Sekundärstrahlen diese Objektivanordnung durchsetzen.

Ferner ist vorteilhafterweise vorgesehen, eine solche Objektivanordnung und einen Strahlablenker integral auszubilden, indem die Strahlumformungsanordnung mit der Blende mit der zusammenhängenden Öffnung für den Durchtritt der mehreren Strahlen diese sowohl hinsichtlich deren Fokussierung als auch hinsichtlich deren Ablenkung beeinflusst.

Die unter diesem Aspekt bereitgestellte teilchenoptische Anordnung kann auch in einem Lithographiesystem angewendet werden. Dann haben die Sondenstrahlen auch die Funktion von Schreibstrahlen, um ein gewünschtes Muster auf eine teilchenempfindliche Schicht ("resist") zu übertragen, wozu die Schreib-/Sonden-Strahlen über die Schicht bewegt werden, die Strahlen die Schicht also abtasten ("scannen") und die Strahlen in geeigneter Weise an- und ausgeschaltet werden, um das gewünschte Muster zu übertragen. Hierbei kann der Schreibvorgang der einzelnen Strahlen durch die Detektion von Sekundärelektronen, welche von den einzelnen Schreib-/Sonden-Strahlen aus der teilchenempfindlichen Schicht herausgelöst werden, überwacht werden. Insbesondere können hierdurch Intensitätsschwankungen oder -änderungen der Schreibstrahlen erfasst werden. Die Anwendung ist somit einerseits eine Lithographieanwendung und andererseits auch eine Mikroskopieanwendung.

Vorzugsweise ist vorgesehen, den Strahlablenker auch integral mit einer Kollimationsanordnung zur Kollimierung der Sondenstrahlen auszubilden, indem die Strahlumformungsanordnung mit der Blende mit der zusammenhängenden Öffnung die mehreren Strahlen sowohl hinsichtlich deren Ablenkung als auch hinsichtlich deren Kollimierung beeinflusst.

Die zusammenhängende Öffnung der Blende der Strahlumformungsanordnung ist vorzugsweise eine quer zur Richtung der Strahlen langgestreckte Öffnung, und die Blende ist vorzugsweise als eine Kammblende ausgebildet, welche beidseits einer Mittelachse der langgestreckten Öffnung jeweils eine mit Abstand von der Mittelachse angeordnete Reihe von mehreren Feld-Quellelementen umfasst. Die Feld-Quellelemente erzeugen jeweils ein elektrisches oder/und magnetisches Feld, wobei sich die von mehreren Feld-Quellelementen erzeugten elektrischen bzw. magnetischen Felder in der Öffnung überlagern und entsprechend einer solchen Überlagerung auf die die Öffnung durchsetzenden Strahlen einwirken. Zur Einstellung von Quellstärken der einzelnen Feld-Quellelemente ist vorzugsweise eine Treiberanordnung vorgesehen. Diese ermöglicht es, innerhalb der Öffnung geeignete elektrische oder/und magnetische Felder durch die Überlagerung zu erzeugen, wobei aufgrund der Vielzahl von Feld-Quellelementen eine Vielzahl von Freiheitsgraden bei der Erzeugung der Feldkonfigurationen des überlagerten Feldes bestehen. So können in der Öffnung Dipolfelder, Quadrupolfelder, Hexapolfelder usw. sowie Überlagerungen derselben bereitgestellt werden, welche auf die Strahlen in auswählbaren Richtungen fokussierend, defokussierend oder ablenkend wirken. Insbesondere können die Feld-Quellelemente elektrische oder/und magnetische Felder erzeugen.

Ein Beispiel einer solchen Kammlinse ist aus DE 199 44 857 A1 bekannt. Darin wird eine solche Kammlinse dazu eingesetzt, um eine fokussierende Linse mit quer zur Strahlrichtung verlagerbarer optischer Achse nährungsweise zu erzeugen. Entsprechend ist diese herkömmliche Kammlinse kombiniert mit einem Strahlablenker, welcher den Teilchenstrahl quer zu dessen Strahlrichtung ablenkt, und die Kammlinse wird dynamisch derart angesteuert, daß die optische Achse von deren Fokussierwirkung im wesentlichen mit der ausgelenkten Strahlachse zusammenfällt.

Die Erfinder haben nun unter anderem herausgefunden, daß die Anwendung einer solchen Kammlinse nicht auf die Fokussierung dynamisch ausgelenkter Teilchenstrahlen beschränkt ist. Vielmehr ist eine solche teilchenoptische Anordnung mit einer langgestreckten Öffnung auch dann vorteilhaft einsetzbar, wenn es darum geht, eine Reihe aus mehreren voneinander separaten Strahlen geladener Teilchen, welche entlang vorbestimmter Strahlachsen statisch, das heißt zeitlich stationär verlaufen und nicht dynamisch ausgelenkt werden, beeinflusst werden sollen.

Entsprechend sieht die Erfindung unter einem zweiten Aspekt eine teilchenoptische Anordnung mit einer Strahlumformungsanordnung vor, um auf eine Mehrzahl von Strahlen geladener Teilchen einzuwirken. Eine Strahlführungsanordnung ist vorgesehen, um die Mehrzahl von Strahlen der Strahlumformungsanordnung derart zuzuführen, daß sie als voneinander separate Strahlen mit Abstand voneinander entlang von vorbestimmten Strahlachsen in die Strahlumformungsanordnung eintritt. Hierbei stellt die Strahlumformungsanordnung für einen jeden Strahl wenigstens einen eigenen räumlichen Bereich mit einem elektrischen oder/und magnetischen Feld zur Beeinflussung des in diesen Feldbereich eintretenden Strahls bereit. Die Strahlumformungsanordnung umfasst zur Bereitstellung der Mehrzahl von Feldbereichen wenigstens eine Blende mit einer zusammenhängenden Öffnung für einen freien Durchtritt der Mehrzahl von Strahlen.

Die Blende kann auch hier als Kammblende ausgebildet sein, wie diese vorangehend beschrieben wurde.

Die Zahl der Feld-Quellelemente pro Reihe ist hierbei größer oder gleich der Anzahl der Strahlen multipliziert mit zwei. Entsprechend wird das Feld zur Beeinflussung eines jeden Strahls durch eine Überlagerung von Feldern erzeugt, welche von wenigstens zwei Feld-Quellelementen ausgehen. Es hat sich herausgestellt, daß für die Erzeugung einer Beeinflussung des Strahls mit ausreichender Qualität nicht eine besonders große Zahl von Feld-Quellelementen pro Strahl bereitzustellen ist. Bereits mit weniger als 15, vorzugsweise weniger als 10 insbesondere 8, 7, 6, 5 oder 4 oder 3 Feld-Quellelementen pro Strahl können gute Ergebnisse erzielt werden.

Die Strahlführungsanordnung umfasst vorzugsweise eine Mehrzahl von Strahlquellen und eine Reihe von fest bezüglich der Strahlquellen angeordnete Blenden, um die Mehrzahl von Strahlen vor deren Eintritt in die Strahlumformungsanordnung zu formen und voneinander zu separieren.

Unter einem weiteren Aspekt sieht die Erfindung vor, eine Kammlinse als teilchenoptische Ablenkanordnung einzusetzen. Es werden hierbei die Quellstärken der einzelnen Feld-Quellelemente derart eingestellt, daß in der von dem Strahl durchsetzten Öffnung der Linse lokal ein den Strahl ablenkendes Dipolfeld durch Überlagerung von von mehreren Feld-Quellelementen ausgehenden Feldern erzeugt wird. Durch den Einsatz der Kammlinse ist es nämlich möglich, ein solches Dipolfeld lokal, das heißt nicht über die gesamte Länge der Öffnung, zu erzeugen, weshalb entsprechende Feldpotentiale gegenüber der Erzeugung der Felder über die gesamte Öffnung deutlich reduziert sind. Insbesondere wird dann nur ein Teil der Quellenelemente in Längsrichtung der beiden Reihen im Hinblick auf die Bereitstellung des Dipolfeldes angesteuert bzw. erregt.

Hierbei ist es bevorzugt, daß die Feld-Quellelemente ferner dem ablenkenden Feld ein den Strahl fokussierendes Feld überlagern, so daß neben der Ablenkung des Strahls auch eine Fokussierung in wenigstens eine Richtung quer zur Strahlrichtung erfolgen kann.

Ferner ist es bevorzugt, daß die einzelnen Feld-Quellelemente zusammen noch Feldkomponenten innerhalb der Öffnung erzeugen, welche eine höhere Ordnung aufweisen als eine Quadrupolordnung. Diese Felder höherer Ordnung können dazu eingesetzt werden, bestimmte Bildfehlerkomponenten des Strahls, welche an anderer Stelle des Strahlengangs erzeugt werden, zu kompensieren. Beispielsweise kann eine Bildfeldwölbung durch die Bereitstellung eines Oktupols manipuliert werden, es kann ein dreizähliger Astigmatismus durch einen Hexapol kompensiert werden, und es kann eine sphärische Aberration mit zwei Hexapolfeldern kompensiert werden, welche im Strahlengang nacheinander angeordnet sind.

Neben der Kompensation von bereits im Strahl bei dessen Eintritt in die Kammlinse vorhandenen Bildfehlerkomponenten können derartige Bildfehler durch die Kammlinse auch gezielt derart erzeugt werden, daß ein solches "Vorhalten" von Bildfehlern im nachfolgenden Strahlengang durch dort entstehende Bildfehler insgesamt zu einer Reduzierung der Bildfehler führt.

Die Erfindung sieht einen Einsatz einer solchen teilchenoptischen Ablenkanordnung in einem Lithographiesystem zur Übertragung eines auf einer Maske definierten Musters mittels wenigstens eines Strahls geladener Teilchen auf ein teilchenempfindliches Substrat vor. Ferner ist ein Einsatz einer solchen teilchenoptischen Ablenkanordnung in einem Mikroskopiesystem zur Erzeugung eines teilchenoptischen Abbilds eines Objekts vorgesehen.

Ferner ist vorgesehen, eine erste und eine zweite teilchenoptische Ablenkanordnung der vorangehend geschilderten Art in einem Strahlengang nacheinander vorzusehen, wobei insbesondere eine durch eine erste der beiden teilchenoptischen Ablenkanordnungen erzeugte Strahlablenkung durch die zweite Ablenkanordnung kompensiert wird, so daß der Strahl nach dem Austritt aus der zweiten Ablenkanordnung in eine gleiche Richtung verläuft wie vor dem Eintritt in die erste Ablenkanordnung, allerdings im Vergleich hierzu parallel versetzt ist.

Vorzugsweise ist der Strahlengang zwischen den beiden Ablenkanordnungen ein teleskopischer Strahlengang, das heißt die von einem Objektpunkt ausgehenden Strahlen verlaufen dort im wesentlichen parallel und werden im wesentlichen scharf in einen Bildpunkt abgebildet. Ein Abstand zwischen den Ablenkanordnungen kann geändert werden ohne die mit dem Strahl durchgeführte Abbildung, abgesehen von einem geänderten Strahlversatz, zu ändern.

Unter einem vierten Aspekt betrifft die Erfindung die Beeinflussung einer Mehrzahl von Strahlen geladener Teilchen durch eine Strahlumformungsanordnung, wobei die Strahlen der Strahlumformungsanordnung derart zugeführt werden, daß sie entlang einer quer zur Richtung der Strahlung orientierten ersten Richtung versetzt zueinander in die Strahlumformungsanordnung eintreten. Sie treten hierbei in einem gemeinsamen räumlichen Feldbereich ein, in welchem ein inhomogenes elektrisches oder/und magnetisches Feld zur Beeinflussung der Strahlen derart herrscht, daß auf einen jeden der Strahlen durch das Feld eine unterschiedliche Wirkung bereitgestellt ist. Im Rahmen der vorliegenden Anmeldung wird durch die Strahlumformungsanordnung ein Feld bereitgestellt, welches in ein oder mehrere Feldbereiche unterteilbar ist. Ist das Feld allerdings in mehrere Feldbereiche unterteilt, so weist wenigstens eine Komponente des Feldes eine Periodizität auf, die der Zahl der Feldbereiche entspricht. Werden in der vorliegend beschriebenen Ausführungsform der Erfindung mehrere Strahlen durch einen gemeinsamen einzigen Feldbereich geleitet, so ist dieser einzige Feldbereich als ein Feldbereich zu verstehen, in dem das Feld keine Feldkomponente aufweist, welche eine der Zahl der Strahlen entsprechende räumliche Periodizität besitzt.

Vorzugsweise ist das Feld in dem gemeinsamen räumlichen Bereich ein Quadrupolfeld, welches auf die Strahlen defokussierend wirkt. Vorzugsweise erfolgt die Defokussierung hierbei in der ersten Richtung, so daß die Strahlumformungsanordnung auf die Reihe Strahlen wie eine Zerstreuungslinse wirkt. Dies bedeutet, daß dann, wenn die mehreren Strahlen beispielsweise parallel zueinander in die Strahlumformungsrichtung eintreten, diese nach der Einwirkung des elektrischen oder/und magnetischen Feldes hinsichtlich ihrer Strahlrichtung divergieren. Hierdurch wird allerdings auch eine Divergenz in den einzelnen Strahlen selbst erzeugt. Vorzugsweise ist deshalb eine weitere Fokussierungseinrichtung vorgesehen, welche für einen jeden Strahl ein separates Feld bereitstellt, um diese in der ersten Richtung wiederum zu kollimieren bzw. zu fokussieren.

Die Strahlumformungsanordnung kann als eine Kammblende ausgeführt sein, wie diese vorangehend beschrieben wurde.

Es ist jedoch auch möglich, die Strahlumformungsanordnung durch eine andere teilchenoptische Vorrichtung bereitzustellen, wie etwa eine herkömmliche Magnetlinse, die ein Quadrupolfeld erzeugt.

Auch hier sieht die Erfindung wiederum die Anwendung der teilchenoptischen Anordnung in einem Lithographiesystem oder in einem Mikroskopiesystem vor.

Ausführungsformen der Erfindung werden nachfolgend anhand von Zeichnungen erläutert. Hierbei zeigt
- Figur 1: eine räumliche aufgebrochene Darstellung einer Kammlinse, wie sie bei Ausführungsformen der Erfindung einsetzbar ist,
- Figur2: eine schematische Darstellung von Feldverläufen zur Erläuterung der in Figur 1 dargestellten Kammlinse,
- Figur 3: eine schematisch räumliche aufgebrochene Darstellung eines Verlaufs eines Teilchenstrahls durch eine Kammlinse, welche auf den Strahl fokussierend wirkt,
- Figur 4: eine schematisch räumliche aufgebrochene Darstellung eines Verlaufs eines Teilchenstrahls durch eine Kammlinse, welche auf den Strahl ablenkend wirkt,
- Figur 5: eine schematische Darstellung einer Kammlinse, welche in deren Öffnung magnetische Felder erzeugt,
- Figur 6: eine schematische Darstellung zur Erläuterung der Funktion einer Kammlinse als Zerstreuungslinse,
- Figur 7: eine schematische Darstellung zur Funktion der Kammlinse in einer Variante zu dem in Figur 6 gezeigten Betriebsmodus,
- Figur 8: eine Elektronenmikroskopievorrichtung gemäß einer Ausführungsform der Erfindung,
- Figur 9: eine Elektronenmikroskopievorrichtung gemäß einer weiteren Ausführungsform der Erfindung,
- Figur 10: eine Elektronenmikroskopievorrichtung gemäß noch einer weiteren Ausführungsform der Erfindung,
- Figur 11: eine Erläuterung zur Funktion eines Detektors in der Elektronenmikroskopievorrichtung gemäß Figur 10,
- Figur 12: ein Detail einer Variante der in Figur 10 gezeigten Elektronenmikroskopievorrichtung,
- Figur 13: eine Variante einer in den in den Figuren 8, 9 und 10 gezeigten Elektronenmikroskopievorrichtungen einsetzbaren Strahlungsquellenanordnung, und
- Figur 14: ein Lithographiesystem gemäß einer Ausführungsform der Erfindung.

In den nachfolgend beschriebenen Ausführungsformen sind hinsichtlich ihrer Funktion und ihres Aufbaus einander entsprechende Komponenten weitgehend mit jeweils gleichen Bezugszeichen versehen. Zum Verständnis der Eigenschaften der jeweiligen Komponenten in einer bestimmten Ausführungsform können deshalb auch die Beschreibungen anderer Ausführungsformen einfach herangezogen werden.

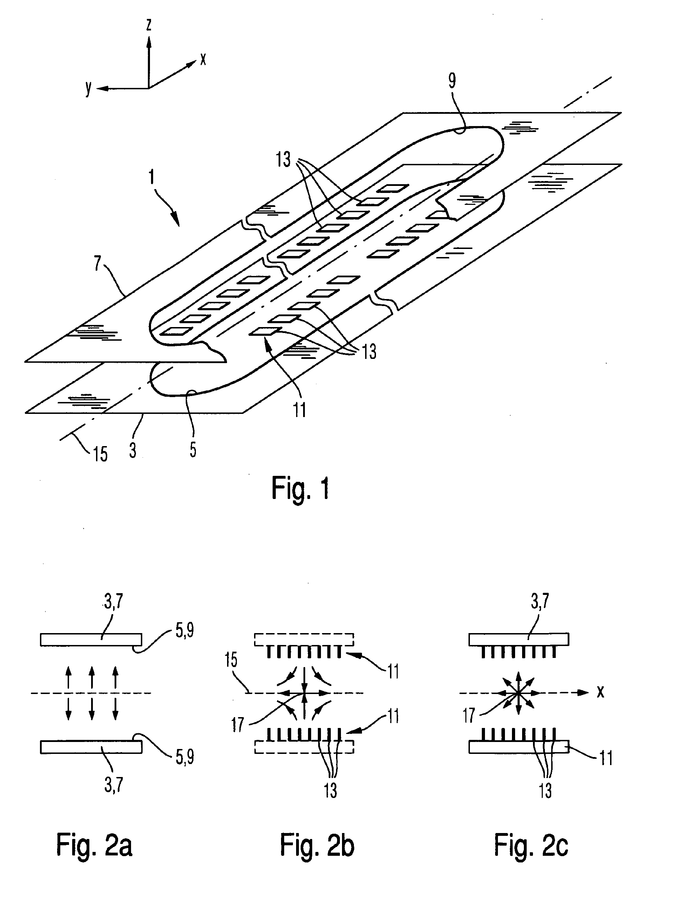

Eine Strahlumformungsanordnung 1, wie sie im Zusammenhang mit der Erfindung einsetzbar ist, ist in Figur 1 in aufgebrochener perspektivischer Darstellung schematisch gezeigt.

Diese umfasst drei in z-Richtung übereinander angeordnete Blenden, nämlich zuunterst eine Blendenelektrode 3 mit einer in x-Richtung langgestreckten Öffnung 5, eine in z-Richtung zuoberst angeordnete Blendenelektrode 7 mit einer ebenfalls in x-Richtung langgestreckten Öffnung 9 sowie einer zwischen den beiden Blendenelektroden 3 und 7 angeordneten Kammblende 11. Die Kammblende 11 umfasst zwei Reihen aus Fingerelektroden 13, welche beidseits einer in x-Richtung sich erstreckenden Mittelachse 15 der Kammblende 11 angeordnet sind. Die beiden Reihen aus Kammelektroden 13 begrenzen damit in y-Richtung einen Raum oberhalb bzw. unterhalb der Öffnungen 5 bzw. 9 in den Blendenelektroden 3 und 7, so daß dieser Raum ebenfalls als eine Öffnung der Kammblende 11 betrachtet werden\kann.

Den beiden Blendenelektroden 3 und 7 sowie den Fingerelektroden 13 werden durch eine in Figur 1 nicht dargestellte Steuerung elektrische Potentiale zugeführt, so daß zwischen den Elektroden 3, 7 und 13 einstellbare elektrische Felder erzeugt werden können. Diese wirken auf einen Strahl elektrisch geladener Teilchen, welcher quer zur xy-Ebene orientiert ist und die Öffnungen der Blenden 7, 11 und 5 durchsetzt. Liegt an den Blendenelektroden 3 oder 7 ein elektrisches Potential an, welches von dem Potential des Strahls geladener Teilchen in der Ebene der Blendenelektroden 3, 7 abweicht, so wirken die Blendenelektroden 3 bzw. 7 auf den Strahl wie eine Zylinderlinse. Ein Verlauf der elektrischen Feldlinien, wie er von einer solchen Blendenelektrode 3, 7 erzeugt wird, ist in Figur 2a schematisch dargestellt.

An die Fingerelektroden 13 der Kammblende 11 kann ein Potentialmuster derart angelegt werden, daß sich in der Öffnung der Blendenelektrode 11 ein elektrisches Quadrupolfeld einstellt. Ein Verlauf von Feldlinien eines solchen Quadrupolfeldes ist in Figur 2b schematisch dargestellt, wobei das Feld eine Symmetrieachse 17 aufweist, die sich in z-Richtung erstreckt und die Längsachse 15 der Kammblende 11 schneidet.

Ein Strahl elektrisch negativ geladener Teilchen, der in dieses Quadrupolfeld eintritt, wird in x-Richtung fokussiert und in y-Richtung defokussiert.

Tritt ein Strahl somit entlang der Symmetrieachse 17 des Quadrupolfeldes in die Strahlumformungsanordnung 1 ein, so erfährt er insgesamt die Wirkungen der durch die Blendenelektroden 3 und 7 bereitgestellten Zylinderlinsenfelder gemäß Figur 2a sowie des durch die Kammblende 11 bereitgestellten Quadrupolfelds gemäß Figur 2b. Der Strahl erfährt somit eine Überlagerung der in den Figuren 2a und 2b dargestellten Feldkonfigurationen, und bei geeigneter Abstimmung der Stärken der Zylinderlinsenfelder und des Quadrupolfeldes aufeinander ergibt sich auf den Strahl eine gleiche Wirkung wie die eines Rundlinsenfeldes, dessen Feldlinien in Figur 2c schematisch dargestellt sind.

Es ist somit möglich, einen Strahl geladener Teilchen mit der Strahlumformungsanordnung 1 bei geeigneter Beaufschlagung der Elektroden 3, 7 und 13 zu fokussieren.

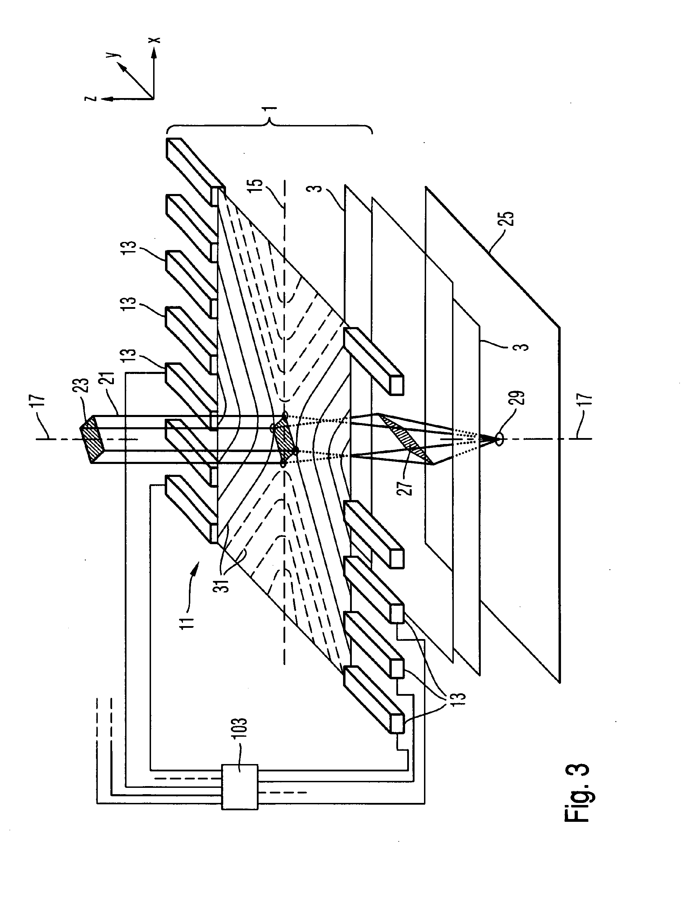

Dies ist in Figur 3 nochmals in räumlicher Darstellung erläutert: Ein Strahl 21 geladener Teilchen mit einem quadratischen Querschnitt 23 tritt entlang einer Symmetrieachse 17 und in z-Richtung in eine Strahlumformungsanordnung 1 ein. Diese umfasst eine Kammblende 11 mit zwei Reihen Fingerelektroden 13 und eine darunterliegende Blendenelektrode 3. Unterhalb der Blendenelektrode 3 ist eine Objektebene 25 angeordnet, in der der Strahl 21 fokussiert werden soll.

An die Fingerelektrode 13 ist von einer Steuerung 103 ein derartiges Potentialmuster angelegt, daß in der Öffnung zwischen den Reihen Fingerelektroden 13 ein elektrisches Quadrupolfeld entsteht, dessen Verlauf in Figur 3 durch elektrische Potentiallinien 31 angedeutet ist. Das Quadrupolfeld fokussiert den Strahl 21 in x-Richtung und defokussiert denselben in y-Richtung. Entsprechend nimmt der Strahlquerschnitt nach Durchlaufen der Kammblende 11 eine Gestalt einer in y-Richtung langgestreckten Raute 27 in der Ebene der Blendenelektrode 3 an. Die Blendenelektrode 3 wirkt auf den Strahl allerdings wie eine Zylinderlinse, welche den Strahl 21 in y-Richtung fokussiert, so daß dieser schließlich in der Objektebene 25 auf einen kleinen Fleck 29 fokussiert ist.

In Figur 1 sind zur Erzeugung des Zylinderlinsenfeldes zwei Blendenelektroden 3 bzw. 7 vorgesehen, während in Figur 3 zur Erzeugung des Zylinderlinsenfeldes lediglich eine Blendenelektrode 3 vorgesehen ist. Es ist jedoch auch möglich, das Zylinderlinsenfeld durch die Kammelektroden 13 selbst bereitzustellen, indem deren mittleres Potential auf einen Wert eingestellt wird, der von dem Potential des Strahls 21 in der Ebene der Kammelektrode abweicht. Damit stellen die Fingerelektroden 13 im Mittel das Zylinderlinsenfeld bereit, und durch ortsabhängige Änderungen der Potentiale der Fingerelektroden 13 wird das zugehörige Quadrupolfeld bereitgestellt.

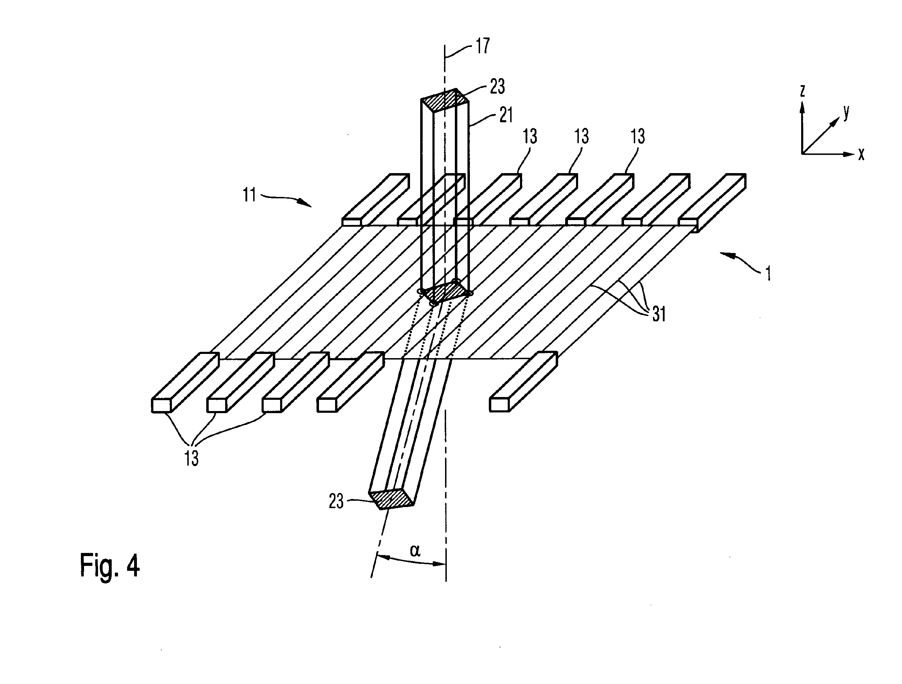

In Figur 4 ist ein Betriebsmodus einer Kammblende 11 dargestellt, der von dem in Figur 3 gezeigten Betriebsmodus zum Fokussieren eines Strahls geladener Teilchen abweicht. In Figur 4 werden die Fingerelektroden 13 durch eine in Figur 4 nicht dargestellte Steuerung derart mit Potentialen beaufschlagt, daß in einer Öffnung zwischen den beiden Reihen von Fingerelektroden 13 ein im wesentlichen homogenes und in x-Richtung orientiertes elektrisches Feld entsteht, dessen Potentiallinien 31 in Figur 4 schematisch eingezeichnet sind. Ein entlang einer in z-Richtung orientierten Strahlachse 17 in die Kammblende 11 eintretender Strahl 21 geladener Teilchen mit quadratischem Querschnitt 23 wird durch das in der Öffnung zwischen den beiden Reihen aus Fingerelektroden 13 gebildete im wesentlichen homogene elektrische Feld in x-Richtung um einen Winkel α abgelenkt, wobei der Querschnitt 23 des Strahls im wesentlichen unverändert bleibt.

Hiermit ist es möglich, die Kammblende 11 als Strahlablenker einzusetzen. Insbesondere kann das den Strahl 21 ablenkende Feld entlang der x-Richtung in der Öffnung zwischen den beiden Reihen Fingerelektroden 13 lokal in einer Umgebung des Strahls 21 bereitgestellt werden, d.h. das elektrische Feld muss sich nicht über die gesamte Länge der Kammblende 11 in x-Richtung erstrecken.

Ferner ist es möglich, die Betriebsmoden der Figuren 3 und 4 zu kombinieren, indem die Fingerelektroden 13 derart mit Potentialen beaufschlagt werden, daß in der Öffnung zwischen den Elektrodenreihen eine Überlagerung des Quadrupolfeldes gemäß Figur 3 und des homogenen Feldes gemäß Figur 4 bereitgestellt ist. Eine derart angesteuerte Kammblende wirkt dann als fokussierender Strahlablenker.

In den vorangehenden beschriebenen Figuren 1 bis 4 wirken die Fingerelektroden 13 jeweils als Quellelemente für das durch die Kammblende 11 bereitgestellte elektrische Feld zur Einwirkung auf den Teilchenstrahl 21.

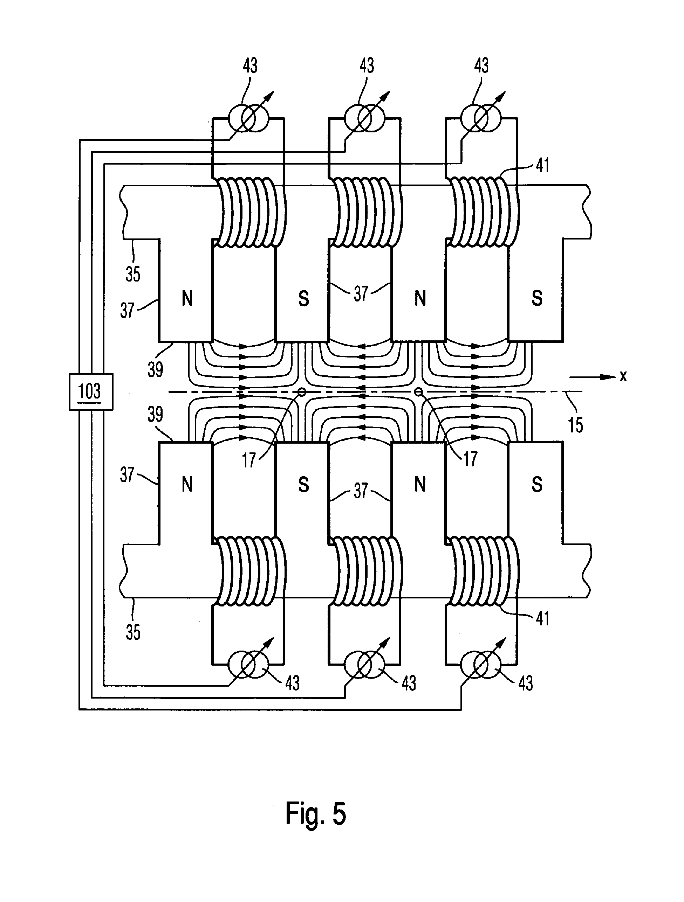

Alternativ ist es jedoch auch möglich, in einer Öffnung einer Kammblende magnetische Felder zum Einwirken auf den Teilchenstrahl bereitzustellen. Eine Realisierung einer solchen Kammblende ist in Figur 5 schematisch dargestellt. Die dort gezeigte Kammblende 11 umfasst zwei Materialstäbe 35, die sich beidseits einer Mittelachse 15 in x-Richtung erstrecken und von denen eine Reihe von Materialfingern 37 in Richtung zu der Mittelachse 15 abstehen. Die Materialfinger 37 sind mit Abstand voneinander angeordnet und weisen jeweils eine zu der Mittelachse 15 hinweisende Stirnfläche 39 auf. Zwischen jeweils zwei benachbarten Materialfingern 37 ist um die Materialstäbe 35 eine Wicklung 41 aus einem elektrisch leitenden Draht gewickelt. Zur Speisung einer jeden Wicklung mit elektrischem Strom ist für eine jede Wicklung eine durch eine in Figur 5 nicht dargestellte Steuerung ansteuerbare Stromquelle 43 angeschlossen, um einer jeden Wicklung 41 einen Strom einstellbarer Stromstärke zuzuführen. Die Stromleiterwicklungen 41 erzeugen dann Magnetfelder, welche u.a. von dem Materialstab 35 und den Material fingern 37 geführt werden. In Figur 5 ist an die Wicklungen 41 ein Strommuster derart angelegt, daß benachbarte Wicklungen 41 jeweils Magnetfelder entgegengesetzter Orientierungen erzeugen. Hierdurch entsteht in einer Öffnung der Kammblende 11 eine Magnetfeldkkonfiguration, wie sie in Figur 5 mit Feldlinie 45 schematisch dargestellt ist. Die Feldkonfiguration ist näherungsweise die von mehreren entlang der Mittelachse 15 benachbart zueinander angeordneten Quadrupolfeldern mit mit Abstand voneinander angeordneten Symmetrieachsen 17.

Das die Materialstäbe 35 und Materialfinger 37 bereitstellende Material ist vorzugsweise ein Material hoher magnetischer Permeabilität, wie beispielsweise Ferritmaterial. Zur Herstellung der magnetischen Feld-Quellelemente in miniaturisierter Form kann eine Technologie verwendet werden, wie sie zur Herstellung von Schreibleseköpfen für Festplatten zur Datenspeicherung bereits eingesetzt wird.

Die in Figur 5 dargestellte Kammblende bildet einen unabhängigen Erfindungsaspekt der vorliegenden Anmeldung, so daß eine entsprechend aufgebaute Strahlumformungsanordnung als deren Merkmale lediglich einen magnetflussführenden Träger aufweist, auf welchen mit Abstand in Längsrichtung des Trägerkörpers angeordnete Spulen vorgesehen sind, zwischen welchen Feld-Quellelemente vorstehen. Zwei Trägerkörper können mit Abstand voneinander und parallel zueinander vorgesehen sein, deren vorstehende Quellelemente aufeinander zuweisen.

Es ist auch möglich, magnetische und elektrische Kammblenden in einer Bauanordnung zu kombinieren, indem beispielsweise die Materialfinger 37 metallisiert werden, um diese als Elektroden auszubilden, denen einstellbare elektrische Potentiale zugeführt werden können. Es ist dann möglich, in der Öffnung zwischen den beiden Reihen von Fingern elektrische und magnetische Felder zu überlagern, um auf Strahlen geladener Teilchen einzuwirken.

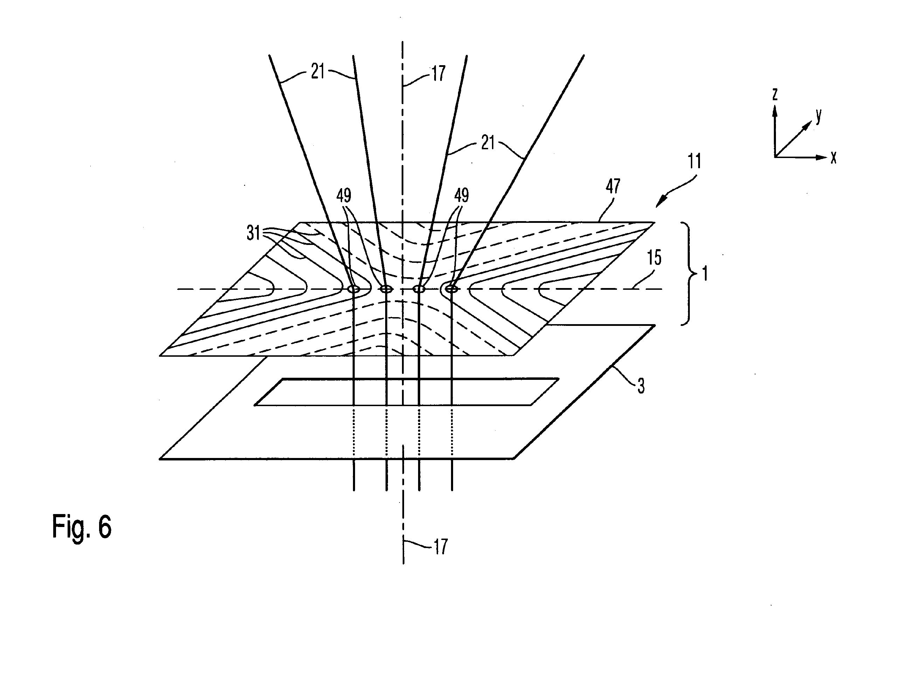

Figur 6 zeigt einen weiteren Betriebsmodus einer Strahlumformungsanordnung 1, welche eine Kammblende 11 und eine Blendenelektrode 3 umfasst. Der einfacheren Darstellung halber sind in Figur 6 Fingerelektroden der Kammblende 11 nicht dargestellt, sondern lediglich ein von diesen Fingerelektroden erzeugtes elektrisches Feld anhand von dessen Äquipotentiallinien 31. Das elektrische Feld ist ein Quadrupolfeld mit einer in z-Richtung sich erstreckenden Symmetrieachse 17. Im Unterschied zu der Figur 3 tritt in dieses elektrische Feld nicht ein einziger Strahl entlang der Symmetrieachse 17 des Feldes ein. Es treten vielmehr vier Strahlen in das Feld ein, welche jeweils in der xz-Ebene derart verlaufen, daß ihr Abstand in x-Richtung sich zur Ebene der Fingerelektröden hin verringert. Die Ebene 47 durchsetzen die Strahlen 21 in Punkten 49, welche auf der Mittelachse 15 liegen und dort mit Abstand voneinander angeordnet sind.

Da die Strahlen 21 nicht entlang der Symmetrieachse 17 des Quadrupolfeldes verlaufen, erfahren sie ein Ablenkfeld, dessen Stärke mit dem Abstand von der Symmetrieachse 17 zunimmt. Entsprechend werden die beiden in x-Richtung außen liegenden Strahlen 21 der Reihe von Strahlen stärker abgelenkt als die beiden mittleren Strahlen 21 der Reihe. Die Ortsabhängigkeit und die Stärke des elektrischen Feldes und die Punkte 41, in denen die Strahlen 21 die Ebene 47 durchsetzen, sind derart aufeinander abgestimmt, daß die oberhalb der Ebene 47 konvergierenden Strahlen unterhalb der Ebene 47 parallel zueinander verlaufen. Die Kammblende 11 hat somit auf die Strahlen 21 die Wirkung einer Zerstreuungslinse.

Es ist jedoch auch möglich, die einzelnen Strahlen der Kammblende parallel zueinander zuzuführen, woraufhin sie diese dann voneinander divergierend verlassen werden.

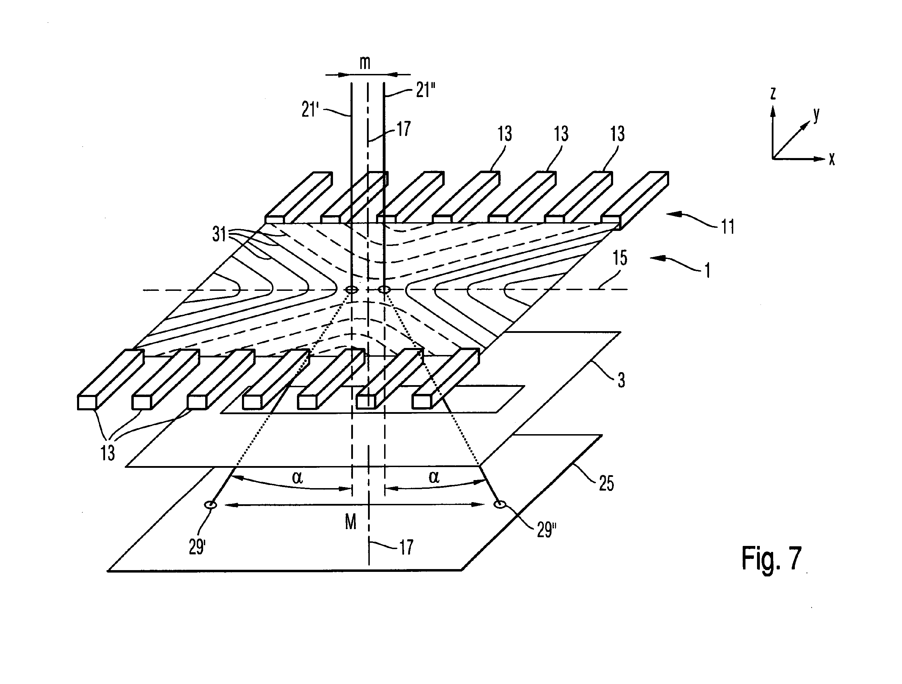

Figur 7 zeigt eine Variante zu Figur 6. Darin sind wiederum eine Blendenelektrode 3 und eine Kammblende 11 in z-Richtung übereinander angeordnet, und Fingerelektroden 13 der Kammblende 11 sind mit derartigen elektrischen Potentialen beaufschlagt, daß ein quadrupolähnliches elektrisches Feld in einer Öffnung der Kammblende 11 zwischen den Reihen von Fingerelektroden 13 erzeugt wird, wobei Äquipotentiallinien 31 dieses Feldes in der xy-Ebene der Kammblende 11 in Figur 7 schematisch dargestellt sind. Im Unterschied zu Figur 6 werden nicht mehrere Strahlen 21 der so gebildeten Strahlumformungsanordnung 1 zugeführt. Es wird vielmehr ein einziger Strahl 21 parallel zur z-Achse derart gerichtet, daß er die Mittelachse 15 der Kammblende 11 schneidet und entlang dieser Mittelachse 15 parallel um eine Strecke m verlagerbar ist. In Figur 7 ist der Strahl in seiner am weitesten links liegenden Verlagerungsstellung mit 21' und in seiner am weitesten rechts liegenden Verlagerungsstellung mit 21" bezeichnet. Der Strahl 21' trifft in die xy-Ebene links neben einer Symmetrieachse 17 des quadrupolähnlichen Feldes, was zu einer Ablenkung des Strahls um einen Winkel α nach links führt, so daß dieser auf einen Fleck 29' in einer Objektebene 21 fokussiert ist. Der Strahl 21" trifft rechts der Symmetrieachse 17 in die xy-Ebene und entsprechend um einen Winkel α nach rechts abgelenkt, so daß er auf einen Fleck 29" in der Objektebene 25 fokussiert wird. Ein Abstand M zwischen den beiden Flecken 29' und 29" ist wesentlich größer als die Strecke m, um die der Strahl 21 vor Eintritt in die Anordnung 1 parallel verlagert wird. Somit ist es möglich, durch eine kleine Verlagerung des einfallenden Strahls um den Betrag m einen wesentlich größeren Bereich über eine Strecke M auf der Objektebene 25 abzutasten.

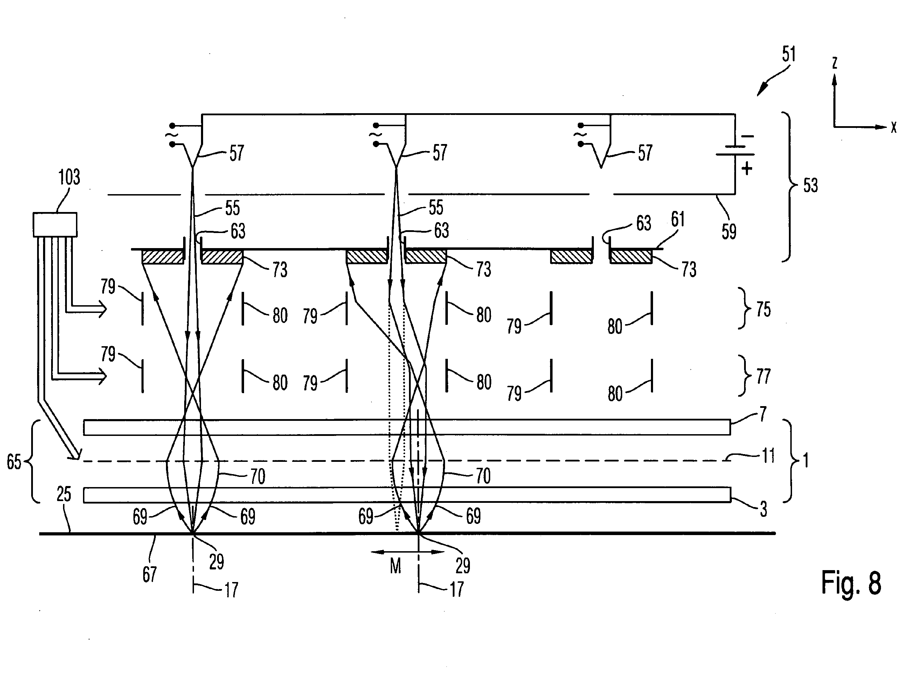

In Figur 8 ist eine Rasterelektronenmikroskopievorrichtung 51 schematisch dargestellt. Diese umfasst eine Strahlungsquellenanordnung 53 zur Erzeugung einer Mehrzahl von Primärelektronenstrahlen 55 mit einer Mehrzahl von Glühkathoden 57 zur Emission von Elektronen, eine Anode 59 zur Extraktion der Elektronen aus den Glühkathoden 57 sowie eine Aperturblende 61 mit einer Mehrzahl Blendenöffnungen 63 zur Formung der mehreren Strahlen 55. In Figur 8 ist die Anordnung 51 zur Bereitstellung von drei Elektronenstrahlen 55 dargestellt. Es ist jedoch möglich, lediglich zwei oder mehr als drei Strahlen entsprechend bereitzustellen.

Die Mikroskopievorrichtung 51 umfasst weiter eine Objektivanordnung 65 zur Fokussierung der Primärelektronenstrahlen 55 in eine Objektebene 25, in der ein zu untersuchendes Objekt, wie beispielsweise ein Halbleiterwafer 67 angeordnet ist. Aus dem Objekt 67 löst der darauf fokussierte Primärelektronenstrahl 55 (Sondenstrahl) Sekundärelektronen aus, deren Bewegung in Figur 8 durch einige exemplarische Bahnen 69 dargestellt ist. Die Sekundärelektronen werden durch ein geeignetes zwischen der Objektivanordnung 65 und dem Objekt 67 angelegtes elektrisches Feld beschleunigt und zu Strahlen 70 geformt, welche die Objektivanordnung durchsetzen und auf unterhalb der Aperturblende 61 angeordnete Detektoren 73 treffen.

Zwischen den Detektoren 73 und der Objektivanordnung 65 sind nacheinander eine erste Ablenkeranordnung 75 und eine zweite Ablenkeranordnung 77 vorgesehen. Die Ablenkeranordnungen 75 und 77 umfassen für einen jeden Primärenelektronenstrahl 55 ein Paar von Ablenkelektroden 79 und 80, welchen von einer Steuerung 103 elektrische Potentiale zugeführt werden, um zwischen einem Elektrodenpaar 79, 80 ein elektrisches Feld zur Ablenkung des Primärelektronenstrahls 55 zu erzeugen. In dem in Figur 8 links dargestellten Strahl 55 liegt bei beiden Ablenkeranordnungen 75 und 77 jeweils keine Spannung an den Elektroden 79, 80 an, so daß die Ablenkeranordnungen 75 und 77 von dem linken Primärelektronenstrahl 55 geradlinig durchsetzt werden.

Bei dem in Figur 8 in der Mitte dargestellten Primärelektronenstrahl 55 liegt an den Elektroden 79, 80 der oberen Ablenkeranordnung 75 eine elektrische Spannung derart an, daß der Primärelektronenstrahl 55 zunächst um einen Winkel nach rechts abgelenkt wird. An den Elektroden 79, 80 der unteren Ablenkeranordnung 77 liegt eine entgegengesetzte Spannung derart an, daß der Primärelektronenstrahl 55 um einen entsprechenden Winkel derart nach links abgelenkt wird, daß er nach Durchlaufen der Ablenkeranordnung 77 wieder parallel zur z-Achse in Richtung zu der Objektivanordnung 65 verläuft. Somit dienen die beiden Ablenkeranordnungen 75, 77 dazu, den in der Objektebene 25 fokussierten Primärelektronenstrahl 55 in der Objektebene parallel zu verlagern, so daß das Objekt 67 mit dem Sondenstrahl abgetastet werden kann.

Die Objektivanordnung 65 umfasst eine einzige Strahlumformungsanordnung 1, wie sie im Zusammenhang mit den Figuren 1 bis 3 erläutert wurde und eine obere Blendenelektrode 7, eine untere Blendenelektrode 3 und eine dazwischen liegende Kammblende 11 umfasst. Die Blendenelektroden 3, 7 und die Kammblende 11 weisen jeweils eine zusammenhängende in x-Richtung durchgehende Öffnung auf, welche von sämtlichen Primärelektronenstrahlen 55 und Sekundärelektronenstrahlen 70 durchsetzt wird.

In Figur 8 nicht einzeln dargestellte Fingerelektroden 13 der Kammblende 11 werden durch die Steuerung 103 derart mit elektrischen Potentialen versorgt, daß für einen jeden Primärelektronenstrahl 55 ein quadrupolähnliches Feld bereitgestellt ist, wie dies anhand der Figur 3 erläutert wurde. Dieses für jeden Primärelektronenstrahl 55 bereitgestellte quadrupolähnliche Feld weist eine Symmetrieachse 17 auf, die mit einer Hauptachse des Primärelektronenstrahls 55 bei Eintritt in die Objektivanordnung 65 zusammenfällt. Damit wirkt das Quadrupolfeld zusammen mit dem durch die Blendenelektroden 3 und 7 bereitgestellten Zylinderlinsenfeld auf die Strahlen fokussierend, wie dies in Figur 3 anschaulich dargestellt ist.

Die Steuerung 103 verlagert nun das an die Fingerelektroden der Objektivanordnung 65 angelegte Spannungsmuster in x-Richtung zusammen mit der Ansteuerung der Ablenkelektroden 79, 80 der Ablenkanordnungen 75, 77, um unabgängig von der Größe des durch die Ablenkanordnungen 75, 77 erzeugten Strahlversatzes M einen im wesentlichen zentralen Einfall des jeweiligen Primärelektronenstrahls 55 in das diesem zugeordnete Quadrupolfeld der Kammelektrode 11 zu gewährleisten, so daß die anhand der Figur 3 erläuterte Fokussierung in der Objektebene 25 im wesentlichen gewährleistet ist.

Somit ist es mit der in Figur 8 gezeigten Mikroskopievorrichtung 51 möglich, ein Objekt mit einer Mehrzahl von Primärelektronenstrahlen 55 gleichzeitig abzutasten und für einen jeden der Primärelektronenstrahlen 55 ein diesem zugeordnetes Sekundärelektronensignal mit den den Strahlen jeweils zugeordneten Detektoren 73 zu erfassen. Hierdurch kann ein elektronenmikroskopisches Abbild des Objekts gewonnen werden.

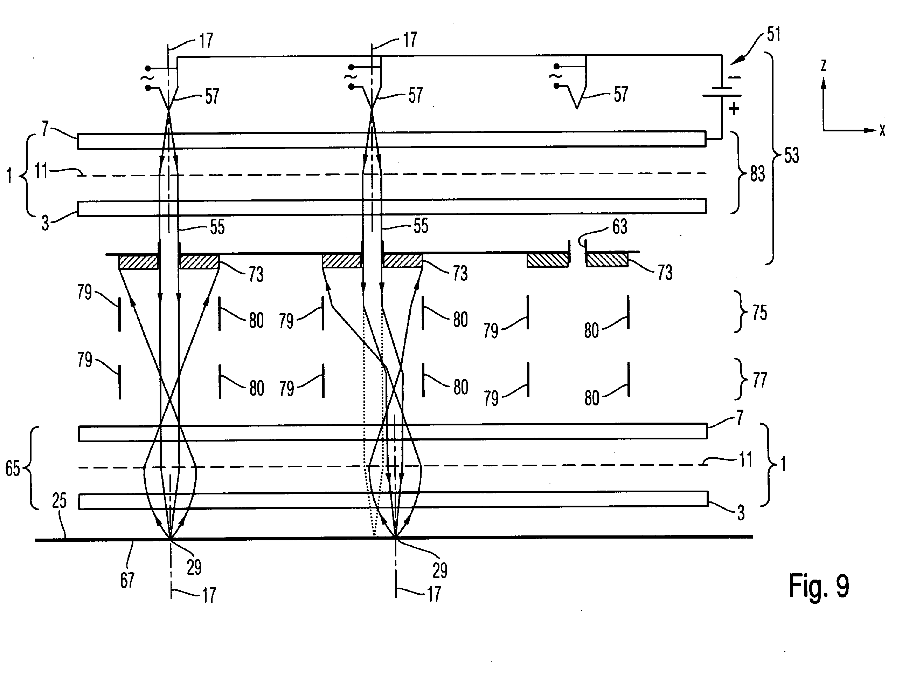

Eine in Figur 9 schematisch dargestellte Mikroskopievorrichtung 51 weist einen ähnlichen Aufbau auf, wie die in Figur 8 dargestellte Mikroskopievorrichtung. Im Unterschied hierzu weist die in Figur 9 gezeigte Mikroskopievorrichtung 51 allerdings eine Strahlformungsanordnung 53 auf, welche Primärelektronenstrahlen 55 jeweils mittels einer gemeinsamen Kollimationsanordnung 83 kollimiert. Die Kollimationsanordnung 83 umfasst wiederum eine Strahlumformungsanordnung 1, wie sie anhand der Figuren 1 bis 3 erläutert wurde und welche ähnlich aufgebaut ist, wie die Strahlumformungsanordnung der Objektivanordnung 65. Somit umfasst die Kollimationsanordnung 83 obere und untere Blendenelektroden 7, 3 und eine dazwischen liegende Kammelektrode 11, welche jeweils eine für sämtliche Primärelektronenstrahlen 55 gemeinsame in x-Richtung sich erstreckende Öffnung aufweisen. Für einen jeden Primärelektronenstrahl 55 stellt die Kammelektrode 11 der Kollimationsanordnung 83 ein quadrupolähnliches elektrisches Feld bezüglich Symmetrieachsen 17 bereit, welche mit den elektronenemittierenden Bereichen der Glühkathoden 57 jeweils fluchten. Die von den Glühkatoden 57 divergent emittierten Elektroden werden durch die kombinierte Wirkung der elektrischen Zylinderlinsen und Quadrupolfelder zu im wesentlichen parallelen Primärelektronenstrahlen 55 kollimiert.

Auch für die Anwendung der Kollimation mehrerer Strahlen ist ein Einsatz der erläuterten Strahlumformungsanordnung 1 vorteilhaft, da diese, im Vergleich zu einer Mehrzahl von für jeden Primärelektronenstrahl 55 separat ausgeführten mehreren Kollimationslinsen einen geringeren Abstand der einzelnen Primärelektronenstrahlen 55 voneinander erlaubt. Ferner ist eine Justierung der einzelnen Linsenfelder relativ zu den gewünschten Strahlachsen bzw. Strahlquellen und Glühkatoden 57 auf elektronische Weise möglich. Mechanische Justageschritte für eine Vielzahl von separaten Kollimationslinsen sind somit nicht nötig.

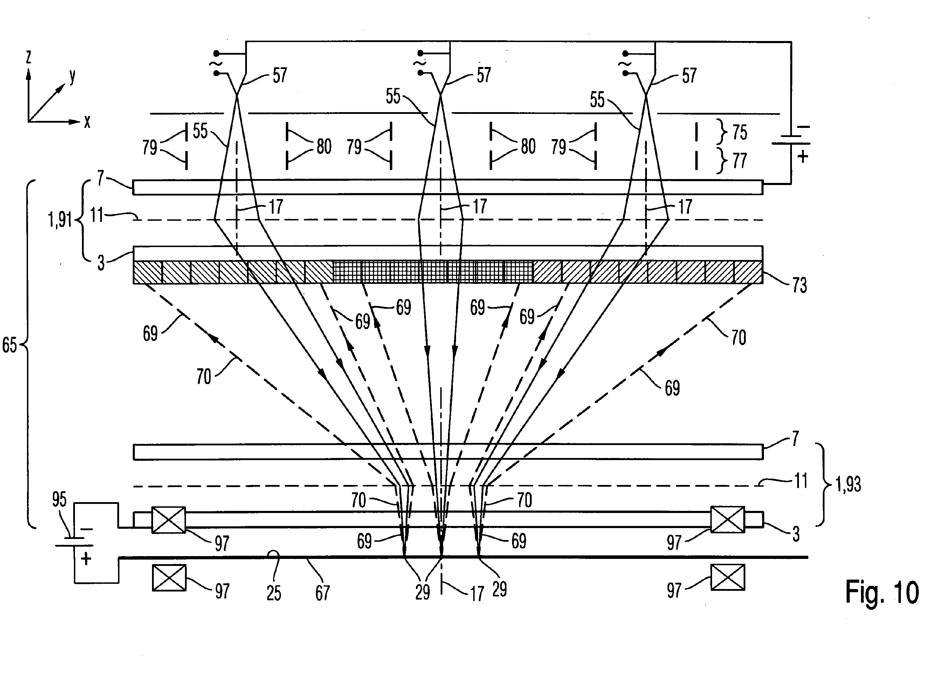

In Figur 10 ist eine weitere Mikroskopieanordnung 51 schematisch dargestellt. Diese umfasst zur Erzeugung von mehreren Primärelektronenstrahlen 55 wiederum eine Strahlformungsanordnung 53 mit einer Mehrzahl Elektronenquellen 57 und einer Aperturblende 59 zur Formung der mehreren Strahlen 55. Eine Objektivanordnung 65 zur Fokussierung der Primärelektronenstrahlen 55 in einer Objektebene 25, in der ein zu untersuchendes Objekt 67 angeordnet ist, umfasst zwei Strahlumformungsanordnungen 1, wie diese anhand der Figuren 1 bis 3 erläutert wurden. Es sind dies eine objektnahe Strahlumformungsanordnung 93 und eine zwischen der objektnahen Strahlumformungsanordnung 93 und der Strahlquellenanordnung 53 angeordnete objektferne Strahlumformungsanordnung 91. Eine jede der Strahlumformungsanordnungen 91, 93 umfasst eine obere Blendenelektrode 7, eine untere Blendenelektrode 3 und eine zwischen diesen angeordnete Kammblende 11, wobei Fingerelektroden der Kammblende 11 in Figur 10 nicht im Detail dargestellt sind.

Die Fingerelektroden der Kammblende 11 der objektfernen Strahlumformungsanordnung 91 werden durch eine in Figur 10 nicht dargestellte Steuerung derart mit elektrischen Potentialen beaufschlagt, daß für einen jeden Primärelektronenstrahl 55 ein Quadrupolfeld mit einer Symmetrieachse 17 bereitgestellt ist, welche mit der jeweiligen Strahlquelle 57 im wesentlichen fluchtet. Damit wirkt die Kammblende 11 zusammen mit den durch die Blendenelektroden 3, 7 bereitgestellten Zylinderlinsenfeldern auf die divergent aus den Ausnehmungen der Blende 59 austretenden Primärelektronenstrahlen 55 fokussierend.

Ferner werden die Fingerelektroden der Kammblende 11 der objektfernen Strahlumformungsanordnung 91 derart angesteuert, daß den einzelnen Quadrupolfeldern mit ihrer Symmetrieachse 17 jeweils ein elektrisches Ablenkfeld überlagert, wie dieses an Hand der Figur 4 vorangehend bereits erläutert wurde. Diese Ablenkfelder werden für einen jeden der Strahlen 55 separat eingestellt, und zwar derart, daß der in Figur 10 links dargestellte Strahl nach rechts abgelenkt wird, der in der Figur 10 zentrale Strahl nicht abgelenkt wird und der in Figur 10 rechts dargestellte Strahl nach links abgelenkt wird, so daß die Primärelektronenstrahl 55 nach Durchlaufen der Strahlumformungsanordnung 91 in sich fokussiert sind und aufeinander zu in der xz-Ebene konvergieren.

Die Fingerelektroden der Kammelektrode 11 der objektnahen Strahlumformungsanordnung 93 werden durch die Steuerung derart mit elektrischen Potentialen beaufschlagt, daß diese in der Öffnung der Kammelektrode für die einzelnen Primärelektronenstrahlen 55 ein quadrupolähnliches elektrisches Feld bereitstellen, wie dies an Hand der Figur 6 vorangehend bereits erläutert wurde. Das quadrupolähnliche Feld ist im wesentlichen symmetrisch bezüglich einer Symmetrieachse 17. Der in Figur 10 in der Mitte dargestellte Primärelektronenstrahl 55 fluchtet vor dem Eintritt in die objektnahe Strahlumformungsanordnung 93 im wesentlichen mit der Symmetrieachse 17 des von deren Kammelektrode 11 bereitgestellten quadrupolähnlichen Feldes. Der linke bzw. rechte Primärelektronenstrahl 55 trifft links bzw. rechts der Symmetrieachse 17 auf die xy-Ebene der Blendenelektrode 11 der unteren Strahlumformungsanordnung 93 und wird, ähnlich wie die äußeren Strahlen 21 der Figur 6 derart durch das quadrupolähnliche Feld abgelenkt, daß nach deren Durchlaufen sämtliche Primärelektronenstrahlen 51 wieder im wesentlichen parallel zur z-Achse ausgerichtet sind und auf die Objektebene 25 an Orten 29 fokussiert sind.

Somit erlaubt es die in Figur 10 gezeigte Mikroskopievorrichtung 51, mehrere Primärelektronenstrahlen 55 äußerst dicht nebeneinander auf das zu untersuchende Objekt 67 zu richten. Ein Abstand der Primärelektronenstrahlen 55 am Objekt 67 ist damit nicht durch einen Bauraum limitiert, welcher für die einzelnen Strahlungsquellen 57 oder zur Formung der Primärelektronenstrahlen 55 benötigte Komponenten vorzusehen ist.

Auf einen jeden einzelnen Strahl wirkt das in dem gemeinsamen Feldbereich bereitgestellte Quadrupolfeld etwas defokussierend in x-Richtung. Dies kann allerdings dadurch kompensiert werden, daß ein derart orientiertes Quadrupolfeld durch die Fokussiereinrichtung 91 bereitgestellt wird, daß durch dieses die Defokussierung der Strahlumformungsanordnung 93 wieder kompensiert wird.

Die in Figur 10 gezeigte Elektronenmikroskopievorrichtung 51 erlaubt auch eine Verlagerung der Orte 29, auf die die Primärelektronenstrahlen 55 in der Objektebene 29 fokussiert sind, in x-Richtung. Hierzu sind zunächst obere und untere Ablenkanordnungen 75 und 77 zwischen der Blende 59 und der objektfernen Strahlumformungsanordnung 91 vorgesehen. Diese sind durch die Steuerung der Mikroskopievorrichtung 51 ansteuerbar, um die Primärelektronenstrahlen 55 bezüglich den Symmetrieachsen 17 der von der objektfernen Strahlumformungsanordnung 91 bereitgestellten Quadrupolfelder parallel zu versetzen. Dies führt zu einem einstellbaren Ablenkwinkel der Primärelektronenstrahlen, ähnlich wie dies anhand der Figur 7 bereits erläutert wurde.

Ferner ist die Stärke der durch die objektferne Strahlumformungsanordnung 91 bereitgestellten Ablenkfelder (vergleiche Figur 4) änderbar, so daß auch hier die Ablenkwinkel der objektfernen Strahlumformungsanordnung 91 für die einzelnen Primärelektronenstrahlen 55 einstellbar sind.

Die Ablenkanordnungen 75 und 77 einerseits und die Strahlumformungsanordnung 91 andererseits stellen somit innerhalb von praktischen Grenzen zwei unabhängige Möglichkeiten bereit, um die Richtung der Strahlen 55 zwischen der objektfernen Strahlumformungsanordnung 91 und der objektnahen Strahlumformungsanordnung 93 zu ändern.

Somit ist es möglich, die Orte 29, an denen die Primärelektronenstrahlen 55 die xy-Ebene der Kammblende 11 der objektnahen Strahlumformungsanordnung 93 durchsetzen, in ihrer Gesamtheit in x-Richtung zu verlagern. Entsprechend der Verlagerung dieser Orte wird dann das Potentialmuster der an die Fingerelektroden der Kammblende 11 der objektnahen Strahlumformungsanordnung 93 angelegten elektrischen Potentiale mitgeführt, so daß ebenfalls die Symmetrieachse 17 der objektnahen Strahlumformungsanordnung 93 mitgeführt wird und die Primärelektronenstrahlen 55 immer im wesentlichen parallel zu einander aus der objektnahen Strahlumformungsanordnung 93 austreten und wieder auf die objektebene 25 fokussiert sind, allerdings versetzt zu den in Figur 10 dargestellten Orten 29.

In Figur 10 ist ebenfalls eine Spannungsquelle 95 dargestellt, um ein elektrisches Extraktionsfeld für Sekundärelektronen 96 zwischen der objektnahen Strahlumformungsanordnung 93 und dem zu untersuchenden Objekt 67 bereitzustellen. Ferner ist in Figur 10 eine Anordnung aus Helmholtz-Spulen 97 dargestellt, welche ein das zu untersuchende Objekt 67 durchsetzendes Magnetfeld erzeugen, um die aus dem Objekt 67 austretenden Sekundärelektronen zu fokussieren und als mehrere im wesentlichen voneinander separierte Sekundärelektronenstrahlen 70 in die objektnahe Strahlumformungsanordnung 93 eintreten zu lassen. Ähnlich wie für die Primärelektronenstrahlen 55 wirkt die objektnahe Strahlumformungsanordnung 93 auch auf die Sekundärelektronenstrahl 70 wie eine Zerstreuungslinse, so daß die Sekundärelektronenstrahlen 70 nach Durchsetzen der objektnahen Strahlumformungsanordnung 93 divergierend in der xz-Ebene verlaufen.

Unterhalb der Blendenelektrode 3 der objektfernen Strahlumformungsanordnung 91 ist ein ortsauflösender Elektronendetektor 73 vorgesehen, welcher allerdings eine mit der in x-Richtung langgestreckten Öffnung der Blendenelektroden 3 im wesentlichen fluchtende Öffnung für den Durchtritt der Primärelektronenstrahlen 55 aufweist. Die Sekundärelektronenstrahlen 70 weisen einen größeren Querschnitt auf als die Primärelektronenstrahlen 55, so daß eine wesentliche Intensität der Sekundärelektronenstrahlen 70 beidseits der in dem Detektor 73 vorgesehenen Öffnung auf denselben trifft.

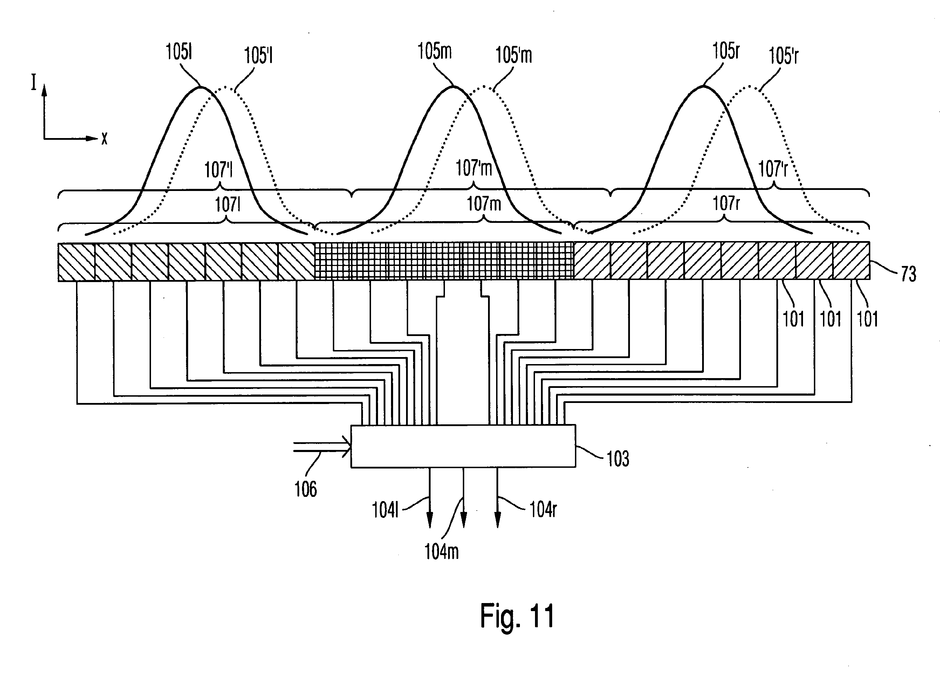

In Figur 11 ist der ortsauflösende Strahlungsdetektor 73 der Elektronenmikroskopievorrichtung 51 der Figur 10 im Detail schematisch dargestellt. Der ortsauflösende Detektor umfasst eine Mehrzahl von elektronenempfindlichen Flächenelementen 101. Eine von einem jeden Flächenelement 101 integral registrierte Elektronenintensität wird von einer Steuerung 103 ausgelesen. Die Reihe der Flächenelemente 101 erstreckt sich in x-Richtung, und in Figur 11 sind Intensitäten I der Sekundärelektronen, die auf den Detektor 73 treffen, in Abhängigkeit von der x-Richtung als Kurven 105l, 105m und 105r schematisch dargestellt. Hierbei repräsentiert die Kurve 105l die durch den in Figur 10 links dargestellten Primärelektronenstrahl 55 hervorgerufenen Sekundärelektronenintensitäten, die Kurve 105m repräsentiert die durch den in Figur 10 mittleren Primärelektronenstrahl 55 hervorgerufenen Sekundärelektronenintensitäten und die Kurve 105r repräsentiert die durch den rechten Primärelektronenstrahl 55 der Figur 10 hervorgerufenen Primärelektronenintensitäten. Aus den Verläufen der Kurven 105l, 105m und 105r ist ersichtlich, daß die Sekundärelektronen, welche den verschiedenen Primärelektronenstrahlen 55 zuzuordnen sind, im wesentlichen auf separierbare räumlich Bereiche des Elektronendetektors 73 treffen.

Entsprechend fasst die Steuerung 103 die Flächenelemente 101 zu separaten Gruppen 107l, 107m bzw. 107r zusammen, wobei eine jede der Gruppen 107l, 107m, 107r einem der Primärelektronenstrahlen 55 eindeutig zugeordnet ist. Die von den einzelnen Flächenelementen 101 einer jeden Gruppe 107l, 107m, 107r erfassten Sekundärelektronenintensitäten werden von der Steuerung 103 addiert, um eine von einem jeden Primärelektronenstrahl 55 hervorgerufene Sekundärelektronenintensität zu bestimmen.

Diese Sekundärelektronenintensitäten werden dann von der Steuerung über Leitungen 104l, 104m, 104r ausgegeben, beispielsweise an eine die gesamte Vorrichtung steuernde zentrale Steuerung, etwa einen Computer. Damit ist auch bei einer großen Zahl von Primärelektronenstrahlen eine an die zentrale Steuerung zu übertragende Datenrate vergleichsweise gering. Die zentrale Steuerung kann über einen Steuerleitung 106 die Steuerung 103 konfigurieren und damit diejenigen Gruppen von Detektorelementen 101 bestimmen, deren Intensität zusammengefasst werden soll. Diese Konfiguration wird dann in Abhängigkeit von einer Auslenkung der Primärelektronenstrahlen erfolgen. Hierbei ist es insbesondere auch möglich, Gruppen von Detektorelementen 101 zusammenzufassen, welche weniger Detektorelemente 101 umfassen, als dies für die Gruppen 107l, 107m, 107r in Figur 11 dargestellt ist. Beispielsweise ist es möglich, für einen jeden Sekundärelektronenstrahl 105 zwei, drei oder mehr Gruppen vorzusehen, deren Intensitäten zusammengefasst werden. Für eine jede Gruppe kann dann eine eigene Leitung 104 vorgesehen sein, um deren zusammengefasste Intensitätswerte an eine zentrale Steuerung zu übertragen, wo dann wiederum Summen einzelner Gruppen gebildet werden können.

Aus Figur 10 ist ersichtlich, daß mit einer Verlagerung der Primärelektronenstrahlen 55 bzw. der Orte 29, an denen die Primärelektronenstrahlen 55 in der Objektebene 25 fokussiert sind, in x-Richtung eine Verlagerung der Bereiche, in denen die Sekundärelektronenstrahlen 77 auf den Detektor 73 treffen, einhergehen wird.

In Figur 11 sind Sekundärelektronenintensitäten, wie sie durch die Primärelektronenstrahlen 55 nach einer Verlagerung der Orte 29 in x-Richtung auf dem Detektor 73 auftreffen, mit Kurven 105'l, 105'm und 105'r dargestellt. Diese sind bezüglich den Kurven 105l, 105m, 105r in x-Richtung verlagert. In dieser Situation ändert die Steuerung 103 die Zusammenfassung der Flächenelemente 101 zu Gruppen 107'l, 107'm bzw. 107'r ab, so daß diese Gruppen wiederum im wesentlichen voneinander separate und den einzelnen Primärelektronenstrahlen 55 zugeordnete Bereiche auf dem Detektor 73 repräsentieren. Es werden dann die von den Flächenelementen 101 der Gruppen 107'l, 107'm bzw. 107'r erfassten Intensitäten zu Sekundärelektronenintensitäten zusammen addiert, welche dann jeweils einem der Primärelektronenstrahlen 55 zugeordnet werden. Die Steuerung 103 ändert die Zusammenfassung der Flächenelemente 101 des Detektors 73 je nach Auslenkung der Primärelektronenstrahlen 55 in der Objektebene 25.

Statt der separaten Detektoren in den in den Figuren 8 und 9 gezeigten Mikroskopievorrichtungen könne in diesen ebenfalls eine oder mehrere ortsauflösende Detektoren eingesetzt werden. Hierbei ist es auch möglich, daß die Steuerung die Zusammenfassung von Detektorelementen zu Gruppen ändert, wenn dies aufgrund einer Verlagerung der Sekundärelektronenintensitäten notwendig ist.

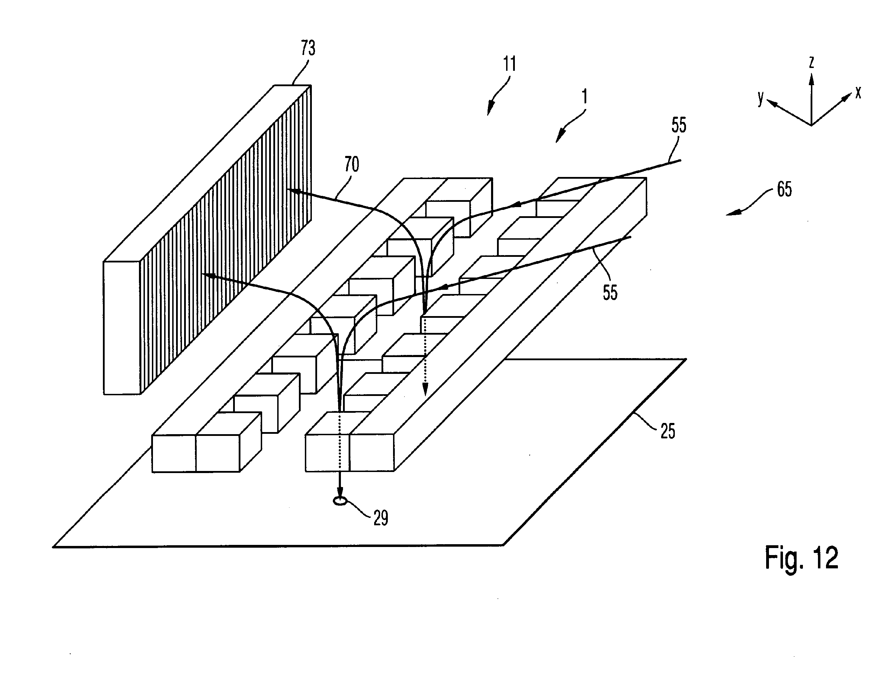

Figur 12 zeigt eine Variante einer Objektivanordnung 65 einer Mikroskopievorrichtung, wie sie beispielsweise vorangehend anhand der Figuren 8, 9 und 10 erläutert wurde. Die Vorrichtung 65 dient wiederum zur Fokussierung von Primärelektronenstrahlen 55 an Orten 29 in einer Objektebene 25.

Die Objektivanordnung 65 umfasst allerdings eine Strahlumformungsanordnung 1 mit einer Kammblende 11, welche Magnetfelder bereitstellt, wie dies anhand der Figur 5 erläutert wurde. Während die in den Figuren 8, 9 und 10 dargestellten Mikroskopievorrichtungen sowohl für Primärelektronen wie auch für Sekundärelektronen Strahlführungen derart aufweisen, daß die mehreren Strahlen in x-Richtung versetzt zueinander, allerdings in einer gemeinsamen xz-Ebene verlaufen, führt das durch die Kammblende 11 der Figur 12 bereitgestellte Magnetfeld zu einer Auslenkung der Strahlen aus der xz-Ebene heraus. Aufgrund der entgegengesetzten Bewegungsrichtungen der Primärelektronenstrahlen 55 und der Sekundärelektronenstrahlen 70 ist auch diese Auslenkung aus der xz-Ebene für die Primärelektronenstrahlen 55 und die Sekundärelektronenstrahlen 70 entgegengesetzt.

Somit ist es möglich, die Strahlen der Primär- und der Sekundärelektronen 55, 70 voneinander zu separieren, und es ist nicht notwendig, den Elektronendetektor 73 derart auszubilden, daß er selbst von den Primärelektronenstrahlen durchsetzt wird. Die hierzu in dem Detektor 73 in den in den Figuren 8, 9 und 10 dargestellten Mikroskopievorrichtungen vorzusehenden Ausnehmungen führen zu einem Verlust registrierter Sekundärelektronenintensität. Dies wird bei der in Figur 12 dargestellten Ausführungsform vermieden, bei der ebenfalls ein ortsauflösender Sekundärelektronendetektor 73 eingesetzt wird. Auch dieser kann, je nach Auslenkung der Primärelektronenstrahlen 55 in x-Richtung, auf unterschiedliche Weise zu Bereichen bzw. Gruppen zusammengefasst sein, wie dies anhand der Figur 11 erläutert wurde.

Zur Separierung des Primärelektronenstrahls von dem Sekundärelektronenstrahl ist es, alternativ zu der anhand von Figur 12 erläuterten Möglichkeit, ebenfalls möglich, die magnetisch arbeitende Kammblende wegzulassen und/oder stattdessen ein im wesentlichen homogenes Magnetfeld bereitzustellen, dessen Feldlinien in etwa parallel zu der Reihe der Orte 29 orientiert sind, an denen die Primärelektronenstrahlen auf der Objektebene 25 fokussiert sind.

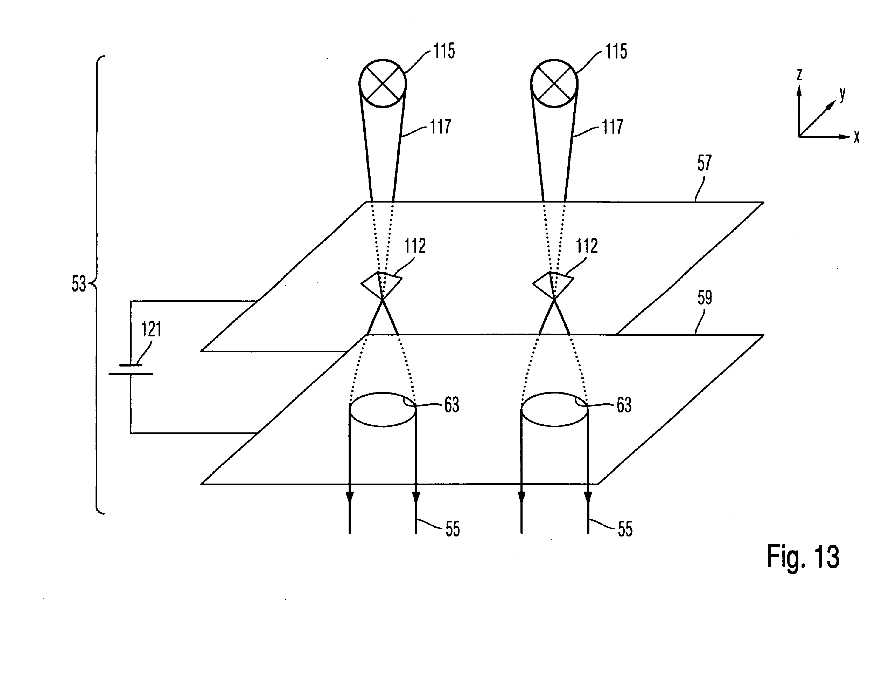

In Figur 13 ist eine Variante der Strahlungsquellenanordnung der anhand der Figuren 8, 9 und 10 erläuterten Mikroskopievorrichtungen schematisch dargestellt. Die in Figur 13 gezeigte Strahlungsquellenanordnung 53 erzeugt zwei Primärelektronenstrahlen 55, ist allerdings auf eine größere Anzahl von Primärelektronenstrahlen erweiterbar.

Die Strahlungsquellenanordnung 53 umfässt eine in der xy-Ebene orientierte Kathodenplatte 57 aus z.B. einem Halbleitermaterial, an welcher zwei in etwa pyramidenförmige Vorsprünge 112 derart ausgeprägt sind, daß diese als Spitzen in z-Richtung nach unten aus der Kathodenplatte 57 vorstehen. Oberhalb der Kathodenplatte 57 sind zwei schematisch dargestellte Strahlungsquellen, wie beispielsweise Laser 115 angeordnet, deren emittierte Lichtstrahlen 117 von oben in die Vorsprünge 112 gerichtet sind, um an den Vorsprüngen 112 infolge einer photonenunterstützten Feldemission Elektronen austreten zu lassen. In z-Richtung unterhalb der Kathodenplatte 57 ist eine Anodenplatte mit Strahlformungsausnehmungen 63 angeordnet, wobei die kreisrunden Ausnehmungen 63 in z-Richtung mit den Vorsprüngen 112 fluchten. Ein durch eine Spannungsquelle 121 zwischen der Kathodenplatte 57 und der Anodenplatte 59 angelegtes elektrisches Feld zieht aus den Vorsprüngen 112 der durch die Laserstrahlen 117 beleuchten Bereiche der Kathodenplatte 57 durch photonenunterstützte Feldemission Elektronen heraus, um die Primärelektronenstrahlen 55 zu formen.

In den voran gehend beschriebenen Ausführungsformen dienen die Kammblenden dazu, die Strahlen in Richtung der Mittelachse 15 der Kammblende auszulenken. Es ist jedoch auch möglich, zwischen den gegenüberliegenden Reihen vor Fingerelektroden der Kammblenden ein quer zur Mittelachse 15 orientiertes elektrisches Feld bereitzustellen, um die Strahlen auch quer zur Längsrichtung der Kammblende, d.h. der y-Richtung in den Figuren 1 bis 13, auszulenken.

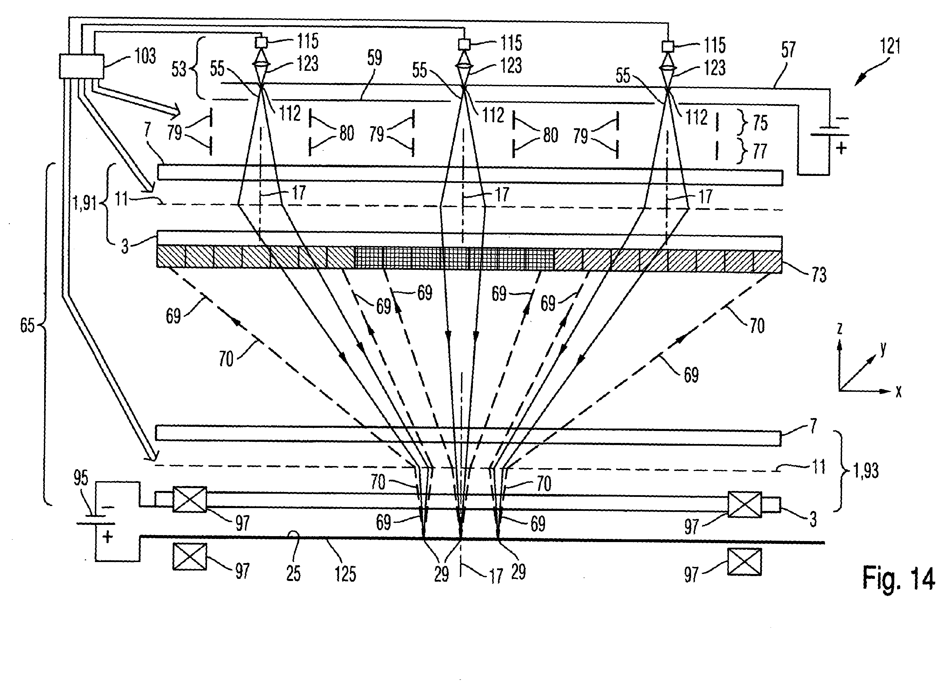

In Figur 14 ist ein Lithographiesystem 121 schematisch dargestellt. Dieses ist hinsichtlich seiner Struktur ähnlich aufgebaut wie die Mikroskopievorrichtung gemäß Figur 10. Allerdings umfasst das Lithographiesystem 121 in einer Strahlungsquellenanordnung 53 Elektronenquellen, wie sie anhand von Figur 13 erläutert wurden. Von Lasern 115 emittiertes Licht wird durch Kollimationslinsen 123 fokussiert und auf Vorsprünge 112 einer Anodenplatte 57 gerichtet. Dort werden dann durch photonenunterstützte Feldemission Elektronen ausgelöst, um die Primärelektronenstrahlen 55 zu erzeugen. Im Unterschied zu den Glühkathoden gemäß Figur 10 sind die Elektronenquellen in dem Lithographiesystem gemäß Figur 14 schnell schaltbar, so daß die Primärelektronenstrahlen 55 auch schnell an- und ausschaltbar sind.

In einer Objektebene 25 ist eine Oberfläche eines Wafers 125 angeordnet, welche mit einem teilchenstrahlungsempfindlichen Lack ("resist") beschichtet ist. Durch eine Steuerung 103 werden die Strahlablenker 75,77,91 und 93 angesteuert, um die Primärelektronenstrahlen 55 zum schreiben eines Musters auf dem teilchenempfindlichen Lack über die Objektoberfläche 25 zu bewegen. Hierbei werden die Laser 115 durch die Steuerung 103 ebenfalls angesteuert, um die Strahlen 55 nach Bedarf an- und aus zuschalten.

Bei dem in Figur 14 gezeigten Lithographiesystem 121 ist es möglich, durch die Schreibstrahlen 55 in dem teilchenempfindlichen Lack ausgelöste Sekundärelektronen mit dem Detektor 73 zu erfassen, wie dies bereits im Zusammenhang mit der Mikroskopievorrichtung gemäß Figur 10 erläutert wurde. Dies bietet den Vorteil, das Schreiben des Musters auf dem Wafer 125 durch die Schreibstrahlen 55 zu kontrollieren. Wenn eine solche Kontrolle des geschriebenen Musters unmittelbar während des Schreibvorgangs nicht nötig ist, können entsprechend der Detektor 73 sowie die Magnetspulen 97 zur Führung der Sekundärelektronen bei dem Lithographiesystem 121 weggelassen werden.

In den anhand der Figuren 8, 9 und 10 erläuterten Mikroskopievorrichtungen und in der anhand der Figur 14 erläuterten Lithographievorrichtung sind Strahlablenker 75, 77 durch Paare 79, 80 von Ablenkelektroden gebildet, wobei für einen jeden Primärelektronenstrahl 55 ein separates Paar von Ablenkelektroden 79, 80 vorgesehen ist. Alternativ hierzu ist es möglich, eine jede Ablenkanordnung 75, 77 durch eine Strahlumformungsanordnung 1 zu ersetzen, deren Fingerelektroden derart angesteuert werden, daß im Bereich eines jeden Primärelektronenstrahls ein elektrisches Ablenkfeld herrscht, wie dies anhand der Figur 4 erläutert wurde.

Bei den anhand der Figuren 8, 9 und 10 erläuterten Mikroskopievorrichtungen und der anhand der Figur 14 erläuterten Lithographievorrichtung wurden in den Strahlumformungsanordnungen 1 jeweils Kammblenden 11 eingesetzt, welche in deren Öffnungen jeweils elektrische Felder bereitstellen. Alternativ hierzu ist es jedoch auch möglich, Kammblenden einzusetzen, die in deren Öffnung magnetische Felder bereitstellen, wie dies anhand der Figur 5 erläutert wurde.

In den Figuren 3, 4, 6 und 7 sind vereinfachte Strahlverläufe und Feldkonfigurationen dahingehend dargestellt, da die Felder schematisch auf eine xy-Ebene beschränkt sind und die Strahlen entsprechend in dieser Ebene einen "Knick" erfahren und außerhalb der Ebene geradlinig verlaufen. In Wirklichkeit sind die Felder jedoch in z-Richtung um die Ebene ausgedehnt, und entsprechend werden die Strahlen ihre Ablenkung nicht als Knick sondern als stetige Kurve erfahren.

Die vorangehend erläuterten Anwendungen beziehen sich auf Elektronenstrahlen, sind jedoch nicht hierauf beschränkt, sondern können auch auf anders geartete Strahlen geladener Teilchen angewendet werden, wie beispielsweise Ionenstrahlen oder Myonenstrahlen usw.

Die vorangehend beschriebenen Sekundärelektronen umfassen sämtliche Arten von Elektronen, welche von einem Primärstrahl aus einem Objekt ausgelöst werden können oder von einem solchen Primärstrahl an dem Objekt hervorgerufen werden können. Insbesondere umfasst der Begriff "Sekundärelektronen" im Rahmen dieser Anmeldung auch Spiegelelektronen, welche an dem Objekt reflektierte Primärelektronen sind, die die Oberfläche des Objekts nicht ganz erreichen, sowie weiter Rückstreuelektronen, welche von der Oberfläche des Objekts emittierte Elektronen sind, die im wesentlichen die gleiche kinetische Energie aufweisen, wie die auf das Objekt gerichteten Primärelektronen, sowie weiter Sekundärelektronen im engeren Sinne, das heißt solche von dem Objekt emittierte Elektronen, die eine kleinere kinetische Energie aufweisen als die auf das Objekt gerichteten Primärelektronen. Ferner sind Sekundärelektronen im Rahmen der vorliegenden Anmeldung auch solche Elektronen, welche beispielsweise durch Einstrahlung von Ionen oder anderen Teilchen aus dem Objekt ausgelöst werden.

Es wird zusammenfassend eine teilchenoptische Vorrichtung vorgeschlagen, welche zum Ablenken mehrerer separater strahlengeladener Teilchen eine teilchenoptische Linse umfasst, die durch eine Mehrzahl von entlang einer Öffnung der Linse vorgesehenen Fingerelektroden bereitgestellt ist.

## Patentansprüche

1. Teilchenoptische Anordnung, umfassend:
eine Strahlumformungsanordnung (93), um auf eine Mehrzahl von Strahlen geladener Teilchen einzuwirken,
eine Strahlführungsanordnung (91), um die Mehrzahl von Strahlen der Strahlumformungsanordnung derart zuzuführen, daß sie entlang einer ersten Richtung versetzt zueinander in die Strahlumformungsanordnung eintreten,
wobei die Strahlumformungsanordnung eine Kammlinse mit wenigstens einer in der ersten Richtung sich erstreckenden Reihe von Feldquellelementen aufweist, um für die Mehrzahl von Strahlen einen gemeinsamen räumlichen Bereich mit einem elektrischen oder/und magnetischen Feld zur Beeinflussung der in den Feldbereich eintretenden Strahlen bereitzustellen.

2. Teilchenoptische Anordnung nach Anspruch 1, wobei das Feld in dem gemeinsamen räumlichen Bereich ein die Strahlen in der ersten Richtung defokussierendes Quadrupolfeld umfasst.

3. Teilchenoptische Anordnung nach Anspruch 1 oder 2, ferner umfassend eine Fokussierungseinrichtung zum Fokussieren der Strahlen in der ersten Richtung.

4. Teilchenoptische Anordnung nach Anspruch 3, wobei die Fokussierungseinrichtung für einen jeden Strahl ein separates Feld bereitstellt, welches ein Quadrupolfeld umfasst.

5. Teilchenoptische Anordnung nach einem der Ansprüche 1 bis 4, wobei die Strahlführungsanordnung wenigstens einen Strahlablenker umfasst, um die Orte, an denen die Strahlen in die Strahlumformungsanordnung eintreten, in der ersten Richtung zu verlagern.

6. Teilchenoptische Anordnung nach Anspruch 5, wobei der Strahlablenker eine Kammlinse umfasst.

7. Teilchenoptische Anordnung nach Anspruch 5 oder 6, wobei eine Hauptachse des in dem gemeinsamen räumlichen Bereich bereitgestellten Feldes in der ersten Richtung verlagerbar ist.

8. Teilchenoptische Ablenkanordnung, um wenigstens einen Strahl (21) geladener Teilchen abzulenken, wobei die Ablenkanordnung (11) umfasst:
eine Kammlinse mit wenigstens einer in einer ersten Richtung sich erstreckenden Reihe von Feld-Quellelementen, und
eine Treiberanordnung zum Ansteuern von Quell-Stärken der einzelnen Feld-Quellelemente derart, daß durch die Feld-Quellelemente in einem von dem Strahl durchsetzten Feldbereich wenigstens ein den Strahl ablenkendes Dipolfeld bereitgestellt ist, wobei der Feldbereich mit dem den Strahl ablenkenden Dipolfeld sich über lediglich einen Teil einer Länge der Reihe der Feld-Quellelemente erstreckt.

9. Teilchenoptische Ablenkanordnung nach Anspruch 8, wobei die Treiberanordnung ferner zum Ansteuern der Quell-Stärken der einzelnen Feld-Quellelemente derart ausgebildet ist, daß in dem Feldbereich ferner ein dem Dipolfeld überlagertes und den Strahl fokussierendes Rundlinsenfeld bereitgestellt ist.

10. Teilchenoptische Ablenkanordnung nach Anspruch 8 oder 9, wobei die Treiberanordnung ferner zum Ansteuern der Quell-Stärken der einzelnen Feld-Quellelemente derart ausgebildet ist, daß in dem Feldbereich ferner ein dem Dipolfeld überlagertes und den Strahl in Richtung der Mittelachse oder/und quer dazu fokussierendes Quadrupolfeld bereitgestellt ist.

11. Teilchenoptische Ablenkanordnung nach einem der Ansprüche 8 bis 10, wobei die Treiberanordnung zum Ansteuern der Quell-Stärken der einzelnen Feld-Quellelemente derart ausgebildet ist, daß in dem Feldbereich ferner ein dem Dipolfeld überlagertes Feld mit einer höheren Ordnung als einer Quadrupolordnung bereitgestellt ist.

12. Strahlführungsanordnung zum Bereitstellen eines Strahlengangs für wenigstens einen Strahl geladener Teilchen, umfassend:
eine Strahlquellenanordnung mit wenigstens einer Strahlquelle, um den wenigstens einen Strahl geladener Teilchen zu erzeugen,
eine erste teilchenoptische Ablenkanordnung nach einem der Ansprüche 8 bis 11, um den von der Strahlquellenanordnung erzeugten Strahl zu formen und um einen einstellbaren ersten Winkel abzulenken,
eine zweite teilchenoptische Ablenkanordnung nach einem der Ansprüche 8 bis 11, um den von der ersten Strahlformungsanordnung geformten Strahl zu fokussieren und um einen einstellbaren zweiten Winkel abzulenken.

13. Strahlführungsanordnung nach Anspruch 12, wobei der Strahlengang zwischen den beiden Strahlformungsanordnungen ein teleskopischer Strahlengang ist.

14. Teilchenoptische Anordnung, insbesondere Rastermikroskopievorrichtung, umfassend:
eine erste Strahlführungsanordnung (53, 65), um eine Mehrzahl von Sondenstrahlen (55) aus geladenen Teilchen im wesentlichen in einer Objektebene (25) zu fokussieren,
eine Detektoranordnung (73) zum Erfassen von Intensitäten von Sekundärteilchen,
eine zweite Strahlführungsanordnung (65), um die aus einem Bereich um die Objektebene (25) ausgehenden Sekundärteilchen als Sekundärstrahlen (70) zu der Detektoranordnung (73) zu führen,
**dadurch gekennzeichnet, daß**
die Detektoranordnung einen ortsauflösenden Detektor (73) mit einer Vielzahl von Detektorelementen umfasst wobei wenigstens einer der Sekundärstrahlen (70) mehreren der Detektorelemente zugeführt ist.

15. Teilchenoptische Anordnung nach Anspruch 14, wobei die Detektoranordnung (73) derart ausgebildet ist, daß für einen jeden Sondenstrahl eine diesem zugeordnete Sekundärteilchen-Intensität erfassbar ist.

16. Teilchenoptische Anordnung nach Anspruch 14 oder 15, wobei die Detektoranordnung (73) eine Steuerung (103) umfasst, welche in Bereichen (107l, 107m, 107r) des Detektors (73), welche den Sondenstrahlen (55) zugeordnet sind, von dem Detektor (73) registrierte Intensitäten bereichsweise zu den Sekundärteilchen-Intensitäten zusammenfasst.

17. Teilchenoptische Anordnung nach einem der Ansprüche 14 bis 16, wobei die Strahlführungsanordnung wenigstens einen Strahlablenker (75, 77) umfasst, um die Orte, an denen die Sondenstrahlen (55) in der Objektebene (25) fokussiert sind, zu verlagern.

18. Teilchenoptische Anordnung nach Anspruch 17, wobei die Steuerung die Bereiche (107l, 107m, 107r) des Detektors (73) in Abhängigkeit von der Verlagerung der Orte, an denen die Sondenstrahlen in der Objektebene fokussiert sind, ändert.

19. Teilchenoptische Anordnung nach einem der Ansprüche 14 bis 18 oder dem Oberbegriff von Anspruch 14, wobei die zweite Strahlführungsanordnung eine von den Sekundärstrahlen (55) durchsetzte Objektivanordnung (65) zur Fokussierung der Sondenstrahlen (55) in der Objektebene (25) umfasst.

20. Teilchenoptische Anordnung nach Anspruch 19, wobei die erste und die zweite Strahlführungsanordnung gemeinsam wenigstens einen von den Sekundärstrahlen (55) durchsetzten Strahlablenker (75, 77) umfassen.

21. Teilchenoptische Anordnung nach Anspruch 20, wobei der Strahlablenker und die Objektivanordnung integral ausgebildet sind, indem sie wenigstens eine gemeinsame Kammlinse mit wenigstens einer in einer ersten Richtung sich erstreckenden Reihe von Feldquellelementen umfassen.

22. Teilchenoptische Anordnung nach einem der Ansprüche 14 bis 21, wobei die erste Strahlführungsanordnung eine Kollimationsanordnung (83) zur Kollimierung der Sondenstrahlen (55) umfasst.

23. Teilchenoptische Anordnung nach Anspruch 22, wobei die erste Strahlführungsanordnung (93) wenigstens einen Strahlablenker umfasst, und wobei der Strahlablenker und die Kollimationsanordnung integral ausgebildet sind, indem sie wenigstens eine gemeinsame Kammlinse mit wenigstens einer in einer ersten Richtung sich erstreckenden Reihe von Feldquellelementen umfassen.

24. Teilchenoptische Anordnung nach einem der Ansprüche 14 bis 23, wobei die Detektoranordnung (73) wenigstens eine Ausnehmung (63) für einen Durchtritt der Sondenstrahlen aufweist.

25. Teilchenoptische Anordnung nach einem der Ansprüche 14 bis 23, wobei die erste und die zweite Strahlführungsanordnung wenigstens einen Strahlseparator umfassen, um den Strahlengang der Sondenstrahlen und den Strahlengang der Sekundärstrahlen voneinander zu separieren.

26. Teilchenoptische Anordnung, umfassend:
eine Strahlumformungsanordnung (33), um auf eine Mehrzahl von Strahlen geladener Teilchen einzuwirken, und
eine Strahlführungsanordnung (57), um die Mehrzahl von Strahlen (55) der Strahlformungsanordnung derart zuzuführen, daß sie als voneinander separate Strahlen mit Abstand voneinander entlang von vorbestimmten Strahlachsen (17) in die Strahlumformungsanordnung eintreten,
wobei die Strahlumformungsanordnung eine Kammlinse mit wenigstens einer in einer ersten Richtung sich erstreckenden Reihe von Feldquellelementen aufweist, um für einen jeden Strahl wenigstens einen räumlichen Bereich mit einem elektrischen oder/und magnetischen Feld zur Beeinflussung der in den Feldbereich eintretenden Strahlen bereitstellt.

27. Teilchenoptische Anordnung nach Anspruch 26, wobei die Strahlführungsanordnung eine Strahlquellenanordnung mit einer Mehrzahl von Strahlquellen (57) umfasst, wobei eine jede der Strahlquellen einen der Strahlen geladener Teilchen erzeugt, und wobei die Strahlquellenanordnung eine Reihe von fest bezüglich der Strahlumformungsanordnung angeordneten Lochblenden vorgesehen ist.

28. Teilchenoptische Anordnung nach einem der Ansprüche 1 bis 27, wobei die elektrischen oder/und magnetischen Felder auf die Strahlen jeweils fokussierend wirken.

29. Teilchenoptische Anordnung nach einem der Ansprüche 1 bis 28, wobei die elektrischen oder/und magnetischen Felder auf die Strahlen jeweils strahlablenkend wirken.

30. Teilchenoptische Anordnung nach einem der Ansprüche 1 bis 29, wobei ein jedes Feld-Quellelement (37) sich in eine quer zu der ersten Richtung orientierte zweite Richtung erstreckt und eine zu einer Mittelachse einer Öffnung der Kammlinse hinweisende Stirnfläche (39) aufweist.

31. Teilchenoptische Anordnung nach einem der Ansprüche 1 bis 29, ferner umfassend eine Treiberanordnung (43) zum Ansteuern von Quell-Stärken der einzelnen Feld-Quellelemente.

32. Teilchenoptische Anordnung nach Anspruch 31, wobei die Feld-Quellelemente jeweils Quellen von elektrischen Feldern sind und die Treiberanordnung dazu ausgebildet ist, an die Feld-Quellelemente einstellbare elektrische Spannungen anzulegen.

33. Teilchenoptische Anordnung nach Anspruch 31 oder 32, wobei die Feld-Quellelemente jeweils Quellen von magnetischen Feldern sind und den Feld-Quellelementen mehrere Wicklungen zugeordnet sind, und wobei die Treiberanordnung dazu ausgebildet ist, die Wicklungen mit einstellbaren elektrischen Strömen zu versorgen.

34. Teilchenoptische Anordnung nach einem der Ansprüche 1 bis 33, wobei eine Anzahl der Feld-Quellelemente in einer jeden der Reihen größer oder gleich zwei Mal der Anzahl der Strahlen ist.

35. Mikroskopiesystem zum Untersuchen eines Objekts, umfassend eine teilchenoptische Anordnung nach einem der Ansprüche 1 bis 34.

36. Lithographiesystem zur Übertragung eines Musters mittels wenigstens eines Schreibstrahls geladener Teilchen auf ein teilchenempfindliches Substrat, umfassend eine teilchenoptische Anordnung nach einem der Ansprüche 1 bis 34.

37. Lithographieverfahren zur Übertragung eines Musters auf ein teilchenempfindliches Substrat mittels wenigstens eines Schreibstrahls, wobei aus dem Substrat durch den Schreibstrahl ausgelöste Sekundärelektronen detektiert werden.

38. Lithographieverfahren nach Anspruch 37, wobei das Muster auf das teilchenempfindliche Substrat mittels mehrerer Schreibstrahlen übertragen wird, und wobei für einen jeden Schreibstrahl eine diesem zugeordnete Sekundärelektronenintensität detektiert wird.
